(19) **Europäisches Patentamt European Patent Office Office européen des brevets**

(11) **EP 3 419 074 B1**

(12) **EUROPEAN PATENT SPECIFICATION**

(45) Date of publication and mention of the grant of the patent:
**14.04.2021 Bulletin 2021/15**

(21) Application number: **17753392.4**

(22) Date of filing: **31.01.2017**

(51) Int Cl.:
*C23F 1/02* (2006.01)    *C23F 1/28* (2006.01)
*C21D 6/00* (2006.01)    *C23C 14/04* (2006.01)
*C21D 8/02* (2006.01)    *C22C 38/08* (2006.01)
*C23F 1/04* (2006.01)    *H01L 51/00* (2006.01)
*G03F 7/00* (2006.01)    *C21D 9/46* (2006.01)

(86) International application number:
**PCT/KR2017/001043**

(87) International publication number:
**WO 2017/142231 (24.08.2017 Gazette 2017/34)**

(54) **METAL PLATE, MASK FOR DEPOSITION AND MANUFACTURING METHOD THEREFOR**

METALLPLATTE, MASKE ZUR ABSCHEIDUNG UND HERSTELLUNGSVERFAHREN DAFÜR

PLAQUE MÉTALLIQUE, MASQUE POUR UN DÉPÔT ET PROCÉDÉ DE FABRICATION ASSOCIÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.02.2016 KR 20160017682**
**01.04.2016 KR 20160040436**

(43) Date of publication of application:
**26.12.2018 Bulletin 2018/52**

(73) Proprietor: **LG Innotek Co., Ltd.**
**Seoul 04637 (KR)**

(72) Inventors:
• **HAN, Tae Hoon**
  **Seoul 04637 (KR)**
• **KIM, Nam Ho**
  **Seoul 04637 (KR)**
• **ROH, Geon Ho**
  **Seoul 04637 (KR)**
• **PARK, Jae Seok**
  **Seoul 04637 (KR)**
• **LEE, Sang Beum**
  **Seoul 04637 (KR)**

(74) Representative: **Novagraaf Technologies**
**Bâtiment O2**
**2, rue Sarah Bernhardt**
**CS90017**
**92665 Asnières-sur-Seine Cedex (FR)**

(56) References cited:
EP-A1- 0 158 178    WO-A1-2013/166951
JP-A- 2003 100 452    JP-A- 2005 281 836
JP-A- 2015 168 847    US-A- 4 303 466
US-A- 4 755 257    US-B1- 6 423 160
US-B2- 8 404 125

**Description**

[Technical Field]

An embodiment relates to a metal plate. Specifically, an embodiment relates to a metal plate capable of being used for a mask for deposition. More specifically, an organic light emitting diode (OLED) panel may be manufactured by using the mask for deposition according to an embodiment.

[Background Art]

As a display device having high resolution and low power consumption is required, various display devices such as a liquid crystal display device and an electroluminescent display device have been developed. Documents EP 0 158 178 A1 and US 4 755 257 A disclose metal plates.

The electroluminescent display device has been spotlighted as a next generation display device due to excellent characteristics such as low light emission, low power consumption, and high resolution, and the like, as compared with the liquid crystal display device.

There are an organic light emitting display device and an inorganic light emitting display device in an electric field display device. That is, an electric field display device may be classified into the organic light emitting display device and the inorganic light emitting display device according to a material of a light emitting layer.

Of these, the organic light emitting display device has received attention because the organic light emitting display device has a wide viewing angle, has a fast response speed, and is required to have low power consumption.

An organic material constituting such a light emitting layer may be formed to have a pattern for forming a pixel on a substrate by a fine metal mask method.

At this point, the fine metal mask, that is, a mask for deposition may have a through-hole corresponding to the pattern to be formed on the substrate, and, patterns of red (R), green (G), and blue (B) forming a pixel may be formed by depositing the organic material after the fine metal mask is aligned on the substrate.

A plurality of through-holes may be formed at a metal plate capable of being used as a mask for deposition by an etching process.

At this point, when the plurality of through-holes are not uniform, uniformity of the deposition may be deteriorated, and as deposition efficiency of a pattern which is formed by the same, may be deteriorated, process efficiency may be deteriorated.

[Disclosure]

[Technical Problem]

The object of the present invention is to provide a metal plate capable of forming uniform through-holes.

[Technical Solution]

A metal plate according to claim 1 used for manufacturing a mask for deposition. The metal plate includes: an outer layer defined by a thickness range of less than or equal to 1 $\mu$m from a surface of the metal plate; and an inner layer other than the outer layer, wherein an etch rate of the outer layer is slower than that of the inner layer, and the etch rate of the outer layer is less than or equal to 0.03 $\mu$m/sec and the etch rate of the inner layer is between 0.03 and 0.05 $\mu$m/sec, which are measured under the etching condition at 45 °C with an etchant containing 35 to 45 wt% of $FeCl_3$.

A manufacturing method of a mask for deposition includes: preparing a base metal plate; rolling the base metal plate; forming a photoresist layer to dispose a first photoresist layer on a first surface of the base metal plate and a second photoresist layer on a second surface of the base metal plate; and etching to form a through-hole through which a first surface hole of the first surface and a second surface hole of the second surface communicate with each other, wherein an etching factor of at least one of the first surface hole and the second surface hole is more than or equal to 2.0 after the etching.

[Advantageous Effects]

The metal plate includes an outer layer defined by a thickness range of less than or equal to 1 $\mu$m from a surface of the metal plate, and an inner layer other than the outer layer.

The metal plate includes two or more crystal planes having different orientations from each other.

A ratio of a {220} crystal plane on a surface of the metal plate is different between the outer layer and the inner layer. The ratio of a {220} crystal plane on the outer layer is greater than that of a {220} crystal plane of the inner layer. That is, the etch rate in the outer layer may be delayed relative to the inner layer by adjusting the ratio of the {220} crystal plane of the outer layer and the inner layer. Accordingly, the metal plate may form uniform through-holes.

That is, the metal plate used for manufacturing a mask for deposition includes the through-holes with improved uniformity, so that the uniformity of a pattern formed via the through-holes may be improved and process efficiency may be improved by increasing the deposition efficiency of the pattern.

In addition, the metal plate according to the embodiment may include grain boundaries having an average size of less than or equal to 30 $\mu$m. The etching characteristics of the metal plate may be improved by adjusting the size of the grain boundaries.

Therefore, an OLED panel manufactured by using the mask for deposition according to the embodiment has excellent deposition efficiency of the pattern and deposition uniformity may be improved.

The metal plate according to the embodiment includes a base metal plate and a surface layer disposed on the base metal plate.

The surface layer is disposed on a first surface of the base metal plate and a second surface opposite to the first surface, respectively, so that etch rates on the first surface and the second surface of the metal plate may be delayed.

Accordingly, the metal plate including the surface layer may form uniform through-holes.

That is, as the metal plate used for manufacturing the mask for deposition includes the through-holes with improved uniformity, the uniformity of the pattern formed via the through-holes may be improved and the process efficiency may be improved by increasing the deposition efficiency of the pattern.

Therefore, the OLED panel manufactured by using the mask for deposition according to the embodiment has the excellent deposition efficiency of the pattern and the deposition uniformity may be improved.

[Description of Drawings]

FIGS. 1 and 2 are conceptual diagrams illustrating a process of depositing an organic material on a substrate.
FIGS. 3 and 4 are views illustrating a front view of a metal plate.
FIG. 5 is a view illustrating a relationship between a crystal plane orientation and a rolling direction of a metal plate.
FIG. 6 is a view of a first embodiment illustrating a cross-sectional view taken along a line A-A' in FIG. 3.
FIGS. 7 to 10 are views illustrating a manufacturing process of a metal plate according to the first embodiment.
FIG. 11 is a view illustrating diffraction intensity of X-rays of Exemplary Embodiment 1 and Comparative Example 1.
FIG. 12 is a graph illustrating etch rates according to etch depths of Exemplary Embodiment 1 and Comparative Example 1.
FIG. 13 is a view of a second embodiment illustrating a cross-sectional view taken along a line A-A' in FIG. 3.
FIGS. 14 to 18 are views illustrating a manufacturing process of a metal plate according to the second embodiment.
FIG. 19 is a photograph of a through-hole of a metal plate according to Exemplary Embodiment 2.
FIG. 20 is a photograph of a through-hole of a metal plate according to Comparative Example 2.
FIG. 21 is a graph illustrating etch rates according to etch depths of Exemplary Embodiments 3 and 4 and Comparative Example 3.
FIG. 22 is a view illustrating a cross-sectional view of a surface hole in an etching process of Exemplary Embodiment 3.
FIG. 23 is a view illustrating a cross-sectional view of a surface hole in an etching process of Exemplary Embodiment 4.
FIG. 24 is a view illustrating a cross-sectional view of a surface hole in an etching process of Comparative Example 3.

[Modes of the Invention]

Hereinafter, embodiments will be described in detail with reference to the accompanying drawings.

In describing with reference to the accompanying drawings, like drawing numerals are used to designate identical elements, and redundant description thereof will be omitted.

Although terms such as "first", "second", etc. can be used to describe elements, the above-described elements should not be limited by the above terms, and are only used to distinguish one element from another.

Also, when a part is referred to as "including" an element, it means that the part may include other elements as well without excluding the other elements unless specifically stated otherwise.

In the drawings, the thickness or the size of each layer (film), region, pattern or structure may be modified for clarity and convenience of explanation, and thus does not entirely reflect the actual size. In the description of the embodiments, in the case in which each layer (film), region pattern or structure is described as being formed "over", "on" or "under" a substrate, each layer (film), area, pad or pattern, the "over", "on" and "under" include both of forming "directly" and "indirectly". Each embodiment may be implemented independently or together, and some elements may be excluded in order to meet objectives of the invention. Hereinafter, embodiments will be described with reference to the accompanying drawings.

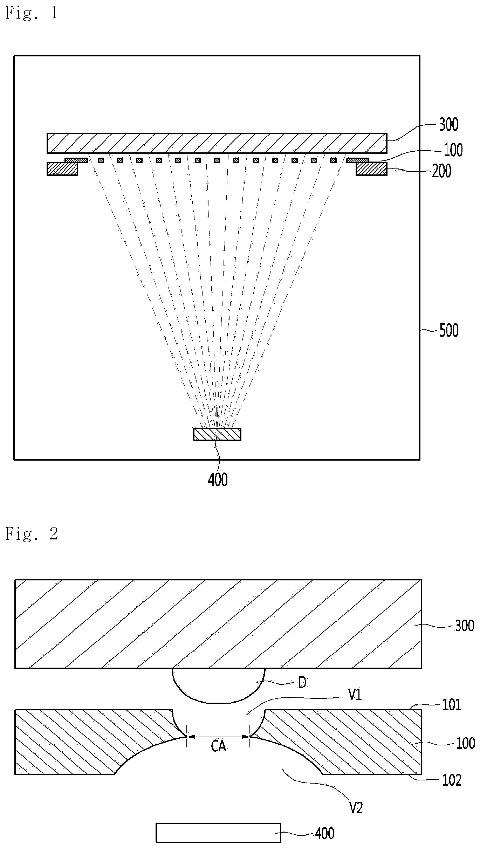

A process for depositing an organic material on a substrate will be described with reference to FIGS. 1 and 2.

FIG. 1 is a view illustrating an organic material deposition apparatus in which a metal plate 100 according to an embodiment is included as a mask for deposition.

The organic material deposition apparatus may include a metal plate 100 used as a mask for deposition, a mask frame 200, a substrate 300, an organic material deposition container 400, and a vacuum chamber 500.

The mask for deposition is a metal plate 100 according to an embodiment. The metal plate 100 may include a plurality of through-holes. At this point, the through-holes may be formed to correspond to patterns to be formed on the substrate.

The mask frame 200 may include an opening. The plurality of through-holes of the metal plate 100 may be disposed on a region corresponding to the opening. Accordingly, organic material supplied to the organic material deposition container 400 may be deposited on the substrate 300.

The mask for deposition may be disposed and fixed on the mask frame 200. For example, the mask for deposition may be tensioned and fixed on the mask frame 200 by welding.

The substrate 300 may be a substrate used for manufacturing a display device. Patterns of red (R), green (G), and blue (B) may be formed on the substrate 300 to form a pixel that is three primary colors of light.

The organic material deposition container 400 may be a crucible. An organic material may be disposed at an inside of the crucible.

As a heat source and/or current is supplied to the crucible in the vacuum chamber 500, the organic material may be deposited on the substrate 300.

FIG. 2 is an enlarged view of one through-hole of the metal plate 100.

The metal plate 100 includes a first surface 101 and a second surface 102 facing the first surface.

The first surface 101 of the metal plate 100 may include a first surface hole V1 and the second surface 102 of the metal plate 100 may include a second surface hole V2.

The through-hole may be formed by a connecting part CA through which the first surface hole V1 and the second surface hole V2 communicate with each other.

A width of the second surface hole V2 may be greater than that of the first surface hole V1. At this point, the width of the first surface hole V1 may be measured at the first surface 101, and the width of the second surface hole V2 may be measured at the second surface 102.

The first surface hole V1 may be disposed toward the substrate 300. Accordingly, the first surface hole V1 may have a shape corresponding to a deposition material D, that is, a pattern.

The second surface hole V2 may be disposed toward the organic material deposition container 400. Accordingly, the second surface hole V2 may accommodate the organic material supplied from the organic material deposition container 400 in a wide width, and a fine pattern may be formed quickly on the substrate 300 through the first surface hole V1 having a width smaller than that of the second surface hole V2.

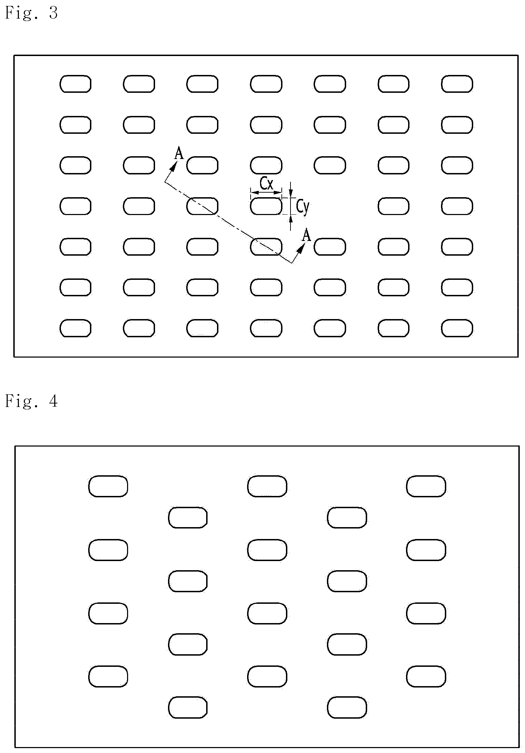

FIGS. 3 and 4 are views illustrating a front view of a metal plate 100.

The metal plate 100 may include a plurality of through-holes. The plurality of through-holes shown in FIG. 3 may represent the second surface hole V2. When a diameter Cx in a horizontal direction and diameter Cy in a vertical direction of a reference hole, which is any one of the through-holes, are measured, deviation of the diameter Cx in the horizontal direction and the diameter Cy in the vertical direction between holes (six holes in total as shown in the drawing) adjacent to the reference hole may be implemented at 2% to 10%, respectively. That is, when a size deviation between adjacent holes of one reference hole is implemented at 2% to 10%, uniformity of the deposition may be ensured.

For example, the size deviation between the reference hole and the adjacent holes may be 4% to 9%. For example, the size deviation between the reference hole and the adjacent holes may be 5% to 7%.

When the size deviation between the reference hole and the adjacent holes is less than 2%, an occurrence rate of moire in an OLED panel after deposition may be increased. When the size deviation between the reference hole and the adjacent holes is more than 10%, an occurrence rate of color stain in the OLED panel after deposition may be increased.

An embodiment may be implemented at a size deviation within $\pm$ 3 $\mu$m between the reference hole and the adjacent holes. Accordingly, deposition efficiency may be improved.

For example, referring to FIG. 3, the through-holes may be disposed in a row in a vertical axis and in a row in a horizontal axis.

For example, referring to FIG. 4, the through-holes may be disposed in a row in the vertical axis and may be disposed to be staggered from each other in the horizontal axis.

The through-hole may have a first diameter measured in the vertical direction and a second diameter measured in the horizontal direction, which may correspond to each other or may be different from each other. The through-hole may have a third diameter measured in a first diagonal direction corresponding to a cross-sectional direction of A-A' and a fourth diameter measured in a second diagonal direction intersecting the first diagonal direction, which may be correspond to each other or may be different from each other. The through-hole may be rounded.

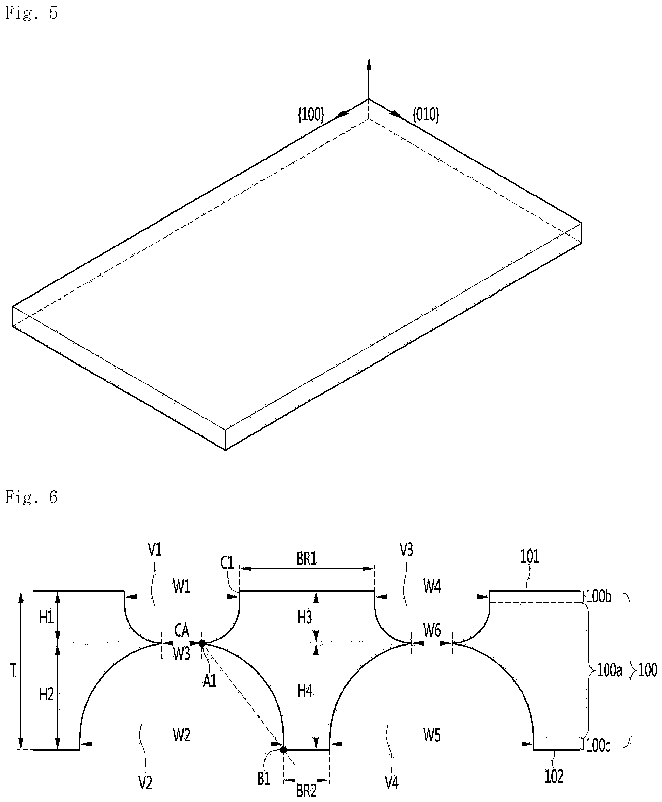

FIG. 5 is a view illustrating a relationship between a crystal plane orientation and a rolling direction of a metal plate.

Most metals are made of a polycrystal. The polycrystal may represent a crystal texture having a preferred orientation by manufacturing processes such as rolling, annealing, heat treatment, and the like.

The metal plate 100 includes invar including about 35 to 37 wt% of nickel, about 63 to 65 wt% of iron, and at least one of a trace amount of C, Si, S, P, Cr, Mo, Mn, Ti, Co, Cu, Fe, Ag, Nb, V, In, and Sb. Herein, the trace amount may refer to less than or equal to 1 wt%. Specifically, herein, the trace amount may refer to less than or equal to 0.5 wt%. Since a nickel alloy such as the invar has a small thermal expansion coefficient, it has advantage that a lifetime of the mask for deposition may be increased. However, it has a problem that uniform etching for the nickel alloy such as the invar is difficult.

That is, in the nickel alloy such as the invar, the through-hole may be enlarged to a side surface as the etch rate increases in an initial stage of the etching, and thus de-filming of a photoresist layer may occur. In addition, when the invar is etched, it may be difficult to form a through-hole having a fine size as a size of the through-hole increases. Further, the through-hole is formed non-uniformly, so that a yield of the mask for deposition may be deteriorated.

The metal plate used in the manufacturing of the mask for deposition according to first and second embodiments includes : an outer layer defined by a thickness range of less than or equal to 1 $\mu$m from a surface of the metal plate; and an inner layer other than the outer layer, wherein an etch rate of the outer layer is slower than that of the inner layer.

First, the first embodiment will be described.

The first embodiment is firstly directed to reducing the etch rate at a surface of the metal plate 100.

The invar of face centered cubic may have a cubic texture re-crystallized by rolling, heat treatment and the like.

For example, in the case of rolled invar, a re-crystal texture may be oriented in the rolling direction, that is, may be {100} oriented in a longitudinal direction of the metal plate. The metal plate 100 includes two or more crystal planes having different orientations from each other. For example, a rolled surface may include {111}, {200} and {220} crystal planes. That is, the surface of the metal plate 100 may include {111}, {200} and {220} crystal planes.

The re-crystal texture may have different etching characteristics depending on a ratio of the crystal plane crystallized on the rolled surface.

As the first embodiment crystallizes the {220} crystal plane on the rolled surface, that is, the surface of the metal plate, the etch rate at the first surface 101 and the second surface 102 of the metal plate 100 may be reduced. That is, an embodiment may reduce the etch rate in the initial stage of the etching, prevent the photoresist layer from being de-filmed or separated, and improve uniformity of the through-hole. In addition, fine through-holes may be formed, and a manufacturing yield of the through-holes and process efficiency may be improved.

The first embodiment in the etching process is secondarily directed that an etching factor of a surface hole is more than or equal to 2.0.

In the first embodiment, since the etching factor of the surface hole is more than or equal to 2.0, the etching characteristics may be excellent, and uniform and fine-sized through-holes may be formed.

The first embodiment is thirdly directed to increasing etching uniformity at a surface of the metal plate 100.

The metal plate 100 according to the first embodiment may include a grain boundary, which has an average size of less than or equal to 30 $\mu$m. The rolled metal plate may include a grain boundary, which has an average size of less than or equal to 30 $\mu$m.

Since the metal plate 100 includes two or more crystal planes having different orientations from each other, the metal plate 100 may include a grain boundary. The grain boundary may have a higher etch rate than a crystal grain. That is, the metal plate 100 according to an embodiment includes a grain boundary having an average size of less than or equal to 30 $\mu$m, thereby increasing uniformity of the etching. Accordingly, a shape of the through-hole may be uniform, and surface roughness of the through-hole may be low.

That is, since the metal plate 100 according to an embodiment includes a grain boundary having an average size of less than or equal to 30 $\mu$m, an inner circumferential surface of the through-hole may be a smooth curved line, and uniformity of a pattern shape to be deposited via the same may be improved.

For example, when an average size of the grain boundary is more than or equal to 30 $\mu$m, the etching may occur along the grain boundary, so that the etching shape may be irregular and the surface roughness of the through-hole may be large. In addition, when the etching shape is non-uniform at the initial stage of the etching, corrosion may proceed in a gap of a non-uniform shape, and the uniformity of the through-hole may be deteriorated. Therefore, uniformity of the pattern shape deposited via the same may be deteriorated.

The metal plate 100 may be ASTM E112 standard, and the number of crystal grains may be 7 to 13. For example, the metal plate 100 may be ASTM E112 standard, and the number of crystal grains may be 7 to 12. For example, the metal plate 100 may be ASTM E112 standard, and the number of crystal grains may be 8 to 11.

When the metal plate according to the first embodiment is ASTM E112 standard, the metal plate may include 7 to 13 crystal grains, and thus the etching characteristics may be excellent, and a through-hole whose inner circumferential surface is smooth may be formed.

FIG. 6 is a view of a first embodiment in which a cross section of a plurality of through-holes is enlarged.

Referring to FIG. 6, the metal plate 100 used for manufacturing the mask for deposition includes an inner layer 100a and outer layers 100b and 100c. For example, the metal plate 100 includes outer layers 100b and 100c defined by the thickness range of less than or equal to 1 $\mu$m from the surface of the metal plate, and an inner layer 100a other than the outer layers.

The metal plate 100 includes a first outer layer 100b defined by a thickness range of less than or equal to 1 $\mu$m from the first surface 101 of the metal plate and a second outer layer 100c defined by a thickness range of less than or equal to 1 $\mu$m from the second surface 102 of the metal plate. For example, the metal plate 100 may include a first outer layer 100b defined by a thickness range of less than or equal to 0.5 $\mu$m from the first surface 101 of the metal plate and a second outer layer 100c defined by a thickness range of less than or equal to 0.5 $\mu$m from the second surface 102 of the metal plate. For example, the metal plate 100 may include a first outer layer 100b defined by a thickness range of less than or equal to 0.1 $\mu$m from the first surface 101 of the metal plate and a second outer layer 100c defined by a thickness range of less than or equal to 0.1 $\mu$m from the second surface 102 of the metal plate. However, embodiments are not limited thereto, and may have various thicknesses. That is, the {220} crystal plane of the outer layer may obviously have various thicknesses within a range of an alloy manufactured to include more than or equal to the {220} crystal plane of the inner layer.

A thickness of the inner layer 100a may be greater than that of the outer layer. For example, the thickness of the inner layer 100a may be greater than that of the first outer layer 100b and that of the second outer layer 100c.

A thickness T of the metal plate 100 may be 10 to 50 $\mu$m. For example, the thickness T of the metal plate 100 may be 10 to 30 $\mu$m. When the thickness T of the metal plate 100 is less than 10 $\mu$m, manufacturing efficiency may be low. When the thickness T of the metal plate 100 is in the range of 10 to 30 $\mu$m to manufacture the mask for deposition, deposition efficiency may be improved.

When the thickness T of the metal plate 100 is more than 50 $\mu$m, process efficiency for forming the through-holes may be deteriorated. Here, the thickness T of the metal plate 100 may be measured after the rolling process.

The thickness of the inner layer 100a may be less than or equal to 50 $\mu$m. For example, the thickness of the inner layer 100a may be less than or equal to 30 $\mu$m.

The first outer layer 100b and the second outer layer 100c may have a thickness corresponding to each other. Here, the "corresponding" may include an error due to tolerance.

The inner layer 100a, the first outer layer 100b, and the second outer layer 100c includes invar.

The inner layer 100a has a different ratio of a crystal plane included in the inner layer 100a from that of the outer layers 100b and 100c.

The ratio of the {220} crystal plane of the metal plate is greater in the outer layers 100b and 100c than the inner layer 100a.

The metal plate 100 is controlled such that the ratio of the {220} crystal plane of the outer layers 100b and 100c is higher than that of the inner layer 100a so that the etch rate in the outer layers 100b and 100c is slower than that of the inner layer 100a. Accordingly, the metal plate 100 according to the first embodiment may have excellent etching characteristics in a thickness direction of the metal plate, that is, in a depth direction of the through-holes, and thus the etching factor may be increased. That is, the metal plate 100 may be controlled such that the ratio of the {220} crystal plane of the outer layers 100b and 100c is higher than that of the inner layer 100a, so that the etch rate in the inner layer 100a may be faster than that of the outer layers 100b and 100c. Accordingly, the metal plate 100 according to the first embodiment can have excellent etching characteristics in the thickness direction of the metal plate, that is, in the depth direction of the through-holes, and the etching factor can be increased.

Therefore, even when a nickel alloy such as the invar is used, the first embodiment may manufacture the mask for deposition which has an excellent etching characteristic and in which etching uniformity of the through-hole is improved.

The ratio of diffraction intensity of X-rays of the inner layer 100a and that of the outer layers 100b and 100c may be different from each other. For example, the ratio of diffraction intensity of X-rays of the {220} crystal plane of the metal plate may be larger in the outer layers 100b and 100c than in the inner layer 100a. Accordingly, it can be seen that the outer layers 100b and 100c have a higher ratio of the {220} crystal plane than the inner layer 100a.

That is, the ratio of the {220} crystal plane of the metal plate 100 according to an embodiment may decrease from the surface as toward the thickness direction of the metal plate. Specifically, in the metal plate 100 according to the embodiment, the ratio of the {220} crystal plane is reduced from the first surface 101 and the second surface 102 to a region between the first surface 101 and the second surface 102, that is, in a middle region having a half thickness of the metal plate 100.

The metal plate 100 may have different widths of through-holes along the thickness direction of the through-hole. For example, a width W1 of the first surface hole V1 may be greater than a width W3 of the connecting part CA. Specifically, the width of the through-hole may be reduced as the first surface hole V1 goes from the first surface 101 toward the connecting part CA. More specifically, the width of the through-hole may be gradually reduced as the first surface hole V1 goes from the first surface 101 toward the connecting part CA.

For example, a width W2 of the second surface hole V2 may be greater than the width W3 of the connecting part CA. Specifically, the width of the through-hole may be reduced as the second surface hole V2 goes from the second surface 102 toward the connecting part CA. More specifically, the width of the through-hole may be gradually reduced as the second surface hole V2 goes from the second surface 102 toward the connecting part CA.

The width of the through-hole may be more than or equal to 20 $\mu$m. For example, the width of the through-hole may be 20 to 40 $\mu$m. For example, at least one of the width W1 of the first surface hole and the width W2 of the second surface hole may have a width of more than or equal to 20 $\mu$m. For example, at least one of the width W1 of the first surface hole and the width W2 of the second surface hole may have a width of 20 to 40 $\mu$m.

A height H2 of the second surface hole V2 may be greater than a height H1 of the first surface hole V1.

Meanwhile, the height H1 of the first surface hole V1 may have a ratio of 1:3 to 30 to the thickness T of the metal plate 100. For example, the height H1 of the first surface hole V1 may have a ratio of 1:3.5 to 12.5 with respect to the thickness T of the metal plate 100. For example, the height H1 of the first surface hole V1 may have a ratio of 1:4.5 to 10.5 in relation to the thickness T of the metal plate 100.

When the height H1 of the first surface hole V1 is more than the ratio in relation to the thickness T of the metal plate 100, the height H1 of the first surface hole V1 is increased and the thickness variation of an organic material is increased and thus, a region in which an organic material is not deposited may occur. Accordingly, a manufacturing yield of the OLED panel manufactured through the mask for deposition may be reduced.

The height H1 of the first surface hole V1 may be 0.1 to 7 $\mu$m. For example, the height H1 of the first surface hole V1 may be 1 to 6 $\mu$m. For example, the height H1 of the first surface hole V1 may be 2 to 4.5 $\mu$m. When the height H1 of the first surface hole V1 is less than 0.1 $\mu$m, deposition efficiency of the organic material via the metal plate may be reduced. When the height H1 of the first surface hole V1 is more than 7 $\mu$m, it is difficult to form a pattern of a fine size and a region in which an organic material is not deposited may occur, and thus the yield of the OLED panel manufactured through the same may be deteriorated.

Meanwhile, since a third surface hole V3 adjacent to the first surface hole V1 and formed on the first surface 101 communicates with a fourth surface hole V4 adjacent to the second surface hole V2 and formed on the second surface 102, through the connecting part CA respectively, a plurality of through-holes may be formed.

The metal plate according to an embodiment may include a bridge region BR between an arbitrary first through-hole and a second through-hole adjacent to the first through-hole. For example, the first surface 101 between the first surface hole V1 and the third surface hole V3 may include a first bridge region BR1, and the second surface 102 between the second surface hole V2 and the fourth surface hole V4 may include a second bridge region BR2.

An inclination angle connecting an arbitrary point A1 of an end of the connecting part CA to an arbitrary point B1 of an end of the second surface hole V2 may be in the range of 20 to 70 degrees. For example, the inclination angle connecting an arbitrary point A1 of an end of the connecting part CA to an arbitrary point B1 of an end of the second surface hole V2 may be in the range of 30 to 60 degrees. For example, the inclination angle connecting an arbitrary point A1 of an end of the connecting part CA to an arbitrary point B1 of an end of the second surface hole V2 may be in the range of 32 to 38 degrees or 52 to 58 degrees. When the inclination angle connecting an arbitrary point A1 of an end of the connecting part CA to an arbitrary point B1 of an end of the second surface hole V2 is in the range of 20 to 70 degrees, uniformity of the deposition may be improved. When the inclination angle is out of the range, a region in which an organic material is not deposited may occur, and thus deposition efficiency and process efficiency may be deteriorated.

The width of the through-hole may become narrower as the first surface hole V1 goes toward a center of the metal plate 100. For example, an inner surface of the first surface hole V1 may be a structure having curvature. In addition, the width of the through-hole may become narrower as the second surface hole V2 goes toward the center of the metal plate 100. For example, the inner surface of the first surface hole V1 may be a structure having curvature. Accordingly, an introduction density of the deposition material may be controlled, and uniformity of the deposition may be improved as compared with a simple slope structure.

A difference W1-W3 between the width W1 of the first surface hole V1 and the width W3 of the connecting part CA may be in the range of 0.2 to 14 $\mu$m.

A vertical distance from an arbitrary point C1 at an end of the first surface hole V1 to an arbitrary point A1 at an end of the connecting part CA may be in the range of 0.1 to 7 $\mu$m. The vertical distance from an arbitrary point C1 at an end of the first surface hole V1 to an arbitrary point A1 at an end of the connecting part CA may be in the range of 1 to 6 $\mu$m. The vertical distance from an arbitrary point C1 at an end of the first surface hole V1 to an arbitrary point A1 at an end of the connecting part CA may be in the range of 2 to 4.5 $\mu$m.

When the vertical distance is less than 0.1 $\mu$m, deposition efficiency of the organic material via the metal plate 100 may be reduced. When the vertical distance is more than 7 $\mu$m, it is difficult to form a pattern of a fine size and a region in which an organic material is not deposited may occur, and thus the yield of the OLED panel manufactured through the same may be deteriorated.

The first surface hole V1 may have a curvature at an edge portion of an open region on the first surface 101, that is, an outer portion of an open region. Alternatively, the second surface hole V2 may have a curvature at an edge portion of an open region on the second surface 102, that is, an outer portion of an open region. For example, the edge portion of the open region may be a rounded structure having curvature of a predetermined range. A diameter of a virtual circle formed by extending the curvature of the rounded portion of the edge portion may be in the range of 5 to 20 $\mu$m. For example, the diameter of a virtual circle formed by extending the curvature of the rounded portion of the edge portion may be in the range of 7 to 15 $\mu$m. The diameter of a virtual circle formed by extending the curvature of the rounded portion of the edge portion may be in the range of 8 to 12 $\mu$m. In the range, the deposition rate is high and an organic material may be deposited uniformly.

When the diameter of a virtual circle formed by extending the curvature of the rounded portion of the edge portion is less than 5 $\mu$m, difference in the deposition rate from the case in which curvature treatment is not performed may not be large. When the diameter of a virtual circle formed by extending the curvature of the rounded portion of the edge portion is more than 20 $\mu$m, the deposition rate may be deteriorated.

A width W5 of the fourth surface hole V4 may be greater than a width W4 of the third surface hole V3. For example, the width W4 of the third surface hole V3 may be greater than a width W6 of the connecting part CA. Specifically, the width of the through-hole may be reduced as the third surface hole V3 goes from the first surface 101 toward the connecting part CA. Specifically, the width of the through-hole may be gradually reduced as the third surface hole V3 goes from the first surface 101 toward the connecting part CA.

For example, the width W5 of the fourth surface hole V4 may be greater than the width W6 of the connecting part CA. Specifically, the width of the through-hole may be reduced as the fourth surface hole V4 goes from the second surface 102 toward the connecting part CA. Specifically, the width of the through-hole may be gradually reduced as the fourth surface hole V4 goes from the second surface 102 toward the connecting part CA.

A height H4 of the fourth surface hole V4 may be greater than a height H3 of the third surface hole V3.

According to the first embodiment, the etch rate of the first outer layer 100b is slower than that of the inner layer 100a. The etch rate of the second outer layer 100c is slower than that of the inner layer 100a.

In the mask for deposition made of the metal plate 100 in which the ratio of the {220} crystal plane of the outer layer is smaller than that of the {220} crystal plane of the inner layer, as the etch rate of the surface of the metal plate 100 in contact with an etchant increases, the width of the through-hole formed at the surface of the metal plate 100 may be increased. Accordingly, it is difficult to form a through-hole having a fine pattern, and a manufacturing yield may be deteriorated. In addition, uniformity of a plurality of through-holes may be deteriorated. Therefore, the OLED panel manufactured through the same may have low deposition efficiency of the pattern, and uniformity of the deposition of the pattern may be deteriorated.

When the ratio of the {220} crystal plane in the outer layers 100b and 100c is greater than the inner layer 100a, the width W1 of the first surface hole V1 may correspond to the width W4 of the third surface hole V3 and the width W2 of the second surface hole V2 may correspond to the width W5 of the fourth surface hole V4.

When the ratio of the {220} crystal plane in the outer layers 100b and 100c is greater than in the inner layer 100a, the height H1 of the first surface hole V1 may correspond to the height H3 of the third surface hole V3 and the height H2 of the second surface hole V2 may correspond to the height H4 of the fourth surface hole V4.

That is, as the ratio of the {220} crystal plane in the outer layers 100b and 100c is greater than in the inner layer 100a, the uniformity of the width and height of the plurality of through-holes may be improved.

The metal plate according to the first embodiment may be formed such that the etch rate of the outer layers 100b and 100c is slower than that of the inner layer so that the through-hole may have a small width and a deep thickness. Accordingly, it possible to prevent a de-filming phenomenon of the photoresist layer from being caused by a rapid etching at a metal surface. Therefore, the mask for deposition according to the first embodiment may form the plurality of through-holes having uniformity, and process efficiency of manufacturing the mask for deposition may be improved.

In addition, the metal plate used for manufacturing the mask for deposition according to the first embodiment may control the etch rate at the surface, and may manufacture a through-hole having a fine pattern. Further, a manufacturing yield of the metal plate used for manufacturing the mask for deposition may be improved, and uniformity of the plurality of through-holes may be improved. Accordingly, the OLED panel manufactured by using such a mask for deposition has excellent deposition efficiency of the pattern and may improve deposition uniformity.

The metal plate 100 used for manufacturing the mask for deposition according to the first embodiment may have different etch rates of the inner layer 100a and the outer layers 100b and 100c.

For example, the etch rate of the outer layers 100b and 100c may be less than or equal to 0.03 $\mu$m/sec. For example, the etch rate of the outer layers 100b and 100c may be less than or equal to 0.01 to 0.03 $\mu$m/sec. For example, the etch rate of the outer layers 100b and 100c may be less than or equal to 0.02 to 0.03 $\mu$m/sec. For example, the etch rate of the outer layers 100b and 100c may be less than or equal to 0.01 to 0.02 $\mu$m/sec.

For example, the etch rate of the inner layer 100a may be 0.03 to 0.06 $\mu$m/ sec. For example, the etch rate of the inner layer 100a may be 0.03 to 0.05 $\mu$m/sec.

That is, the metal plate used for manufacturing the mask for deposition according to an embodiment may have an etch rate of the outer layers 100b and 100c which is slower than an etch rate of the inner layer 100a, so that the etching characteristics of the through-holes may be excellent. In addition, the OLED panel manufactured by using the mask for deposition according to an embodiment has excellent deposition efficiency of the pattern and may improve deposition uniformity.

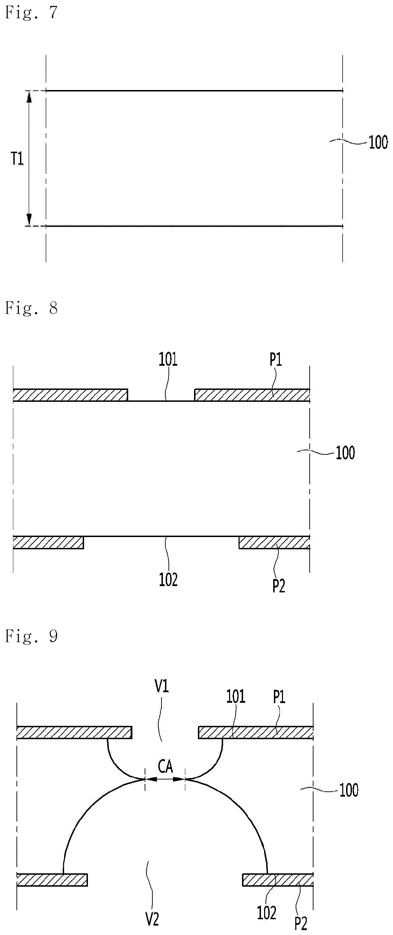

Referring to FIGS. 7 to 10, a manufacturing process of a mask for deposition according to the first embodiment will be described.

A manufacturing method of a mask for deposition according to the first embodiment may include: preparing a base metal plate; rolling the base metal plate; forming a photoresist layer on a first surface of the base metal plate and disposing a second photoresist layer on a second surface; and etching to form a through-hole through which a first surface hole of the first surface and a second surface hole of the second surface communicate with each other.

Then, the mask for deposition including a plurality of through-holes may be manufactured by removing the photoresist layer.

First, the preparing of a base metal plate will be described. In the base metal plate, a nickel alloy is prepared. The base metal plate is invar including about 35 to 37 wt% of nickel, about 63 to 65 wt% of iron, and at least one of a trace amount of C, Si, S, P, Cr, Mo, Mn, Ti, Co, Cu, Fe, Ag, Nb, V, In, and Sb.

Then, the rolling of the base metal plate will be described with reference to FIG. 7. The rolled base metal plate 100 may have a thickness T1 of less than or equal to 50 $\mu$m. At this point, the base metal plate 100 has different crystal planes of an outer layer corresponding to a thickness range of less than or equal to 1 $\mu$m from the surface of the base metal plate and inner layers other than the outer layer by rolling. The ratio of the {220} crystal plane of the outer layer is greater than that of the {220} crystal plane of the inner layer.

Then, the forming of a photoresist layer will be described with reference to FIG. 8. A first photoresist layer P1 may be disposed on the first surface 101 of the base metal plate and a second photoresist layer P2 may be formed on the second surface 102 of the base metal plate.

Specifically, a photoresist material may be coated on the first surface 101 and the second surface 102 of the base metal plate, respectively and the first photoresist layer P1 and the second photoresist layer P2 may be disposed by an exposure and development process, respectively.

The first photoresist layer P1 and the second photoresist layer P2 are disposed such that widths of open regions are different from each other, so that the width of the first surface hole V1 formed on the first surface 101 and the width of the second surface hole V2 formed on the second surface 102 may be different.

Then, referring to FIG. 9, the etching will be described. In an etching process, a first surface hole V1 of the first surface 101 and a second surface hole V2 of the second surface 102 may be formed and a through-hole may be formed as the first surface hole V1 and the second surface hole V2 communicate with each other by the connecting part CA.

For example, the etching process may be performed by a wet etching process. Accordingly, the first surface 101 and the second surface 102 may be simultaneously etched. For example, the wet etching process may be performed at about 45 °C by using an etchant containing iron chloride. At this point, the etchant may contain 35 to 45 wt% of FeCl$_3$. Specifically, the etchant may contain 36 wt% of FeCl$_3$. For example, specific gravity of the etchant containing 43 wt% of FeCl$_3$ may be 1.47 at 20 °C. The specific gravity of the etchant containing 41 wt% of FeCl$_3$ may be 1.44 at 20 °C. The specific gravity of the etchant containing 38 wt% of FeCl$_3$ may be 1.39 at 20 °C.

After the etching, an etching factor of at least one of the first and second surface holes calculated by Equation 1 may be more than or equal to 2.0.

<Equation 1>

$$EtchingFactor = \frac{2C}{B\text{-}A}$$

In the equation, the B may be a width of an etched surface hole,
the A may be a width of an opened photoresist layer, and
the C may refer to a depth of the etched surface hole.

As the etching factor becomes larger, it may mean that the etching characteristics are excellent in the thickness direction of the metal plate, that is, the depth direction of the through-hole.

As the etching factor becomes smaller, it means that the width of the through-hole is larger. That is, since the width of the through-hole increases as the etching factor becomes smaller, a phenomenon that the photoresist layer is lifted or separated may occur.

When the etching factor is more than or equal to 2.0, the width of the surface hole is small and the etching characteristics in the depth direction may be excellent. In addition, when the etching factor is more than or equal to 2.0, a contact area between the photoresist layer and the bridge region BR may be widened, and the de-filming of the photoresist layer may be stably prevented. Accordingly, a fine deposition pattern may be formed via the mask for deposition according to an embodiment.

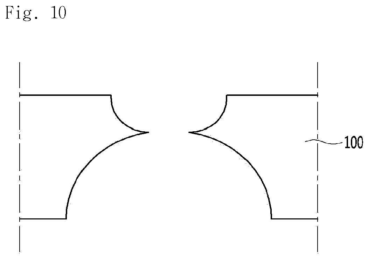

Then, referring to FIG. 10, the metal plate having a plurality of through-holes may be formed by removing the first photoresist layer P1 and the second photoresist layer P2.

Hereinafter, the first embodiment will be described in detail with reference to exemplary embodiments and comparative examples. Such an embodiment is merely an example in order to explain the present invention in more detail. Therefore, the present invention is not limited to such an embodiment.

<Experimental Example 1: Measurement of diffraction intensity of X-rays>

Exemplary Embodiment 1

Rolled and annealed invar metal was prepared, and a re-crystal texture was formed by a rolling process.

At this point, an outer layer of the invar metal was formed such that the ratio of the {220} crystal plane was greater than that of an inner layer other than the outer layer.

Then, the diffraction intensity of X-rays was measured.

The diffraction intensity of X-rays was measured at the outer layer in a thickness range of less than or equal to 1 $\mu$m from a surface of the invar metal, was measured at the inner layer located at a region of a depth of 10 $\mu$m from the surface of the invar metal, and was measured at the inner layer located at a region of a depth of 15 $\mu$m from the surface of the invar metal.

Comparative Example 1

Rolled and annealed invar metal was prepared, and a re-crystal texture was formed by a rolling process.

At this point, an outer layer of the invar metal was formed such that the ratio of the {220} crystal plane was smaller than that of an inner layer other than the outer layer.

Then, the diffraction intensity of X-rays was measured.

The thickness of invar metal and the diffraction intensity of X-rays were the same as those of Exemplary Embodiment 1, except that rolling conditions were different.

It can be seen that the distribution of a crystal plane is indicated by diffraction analysis of X-rays of experimental example 1. Since an embodiment is a polycrystal in which various crystal planes are non-uniformly mixed, it can be seen that several peaks indicate different intensities.

It can be seen that the ratio of the crystal plane disposed on the surface of the metal plate is indicated by measurement of the diffraction intensity of X-rays.

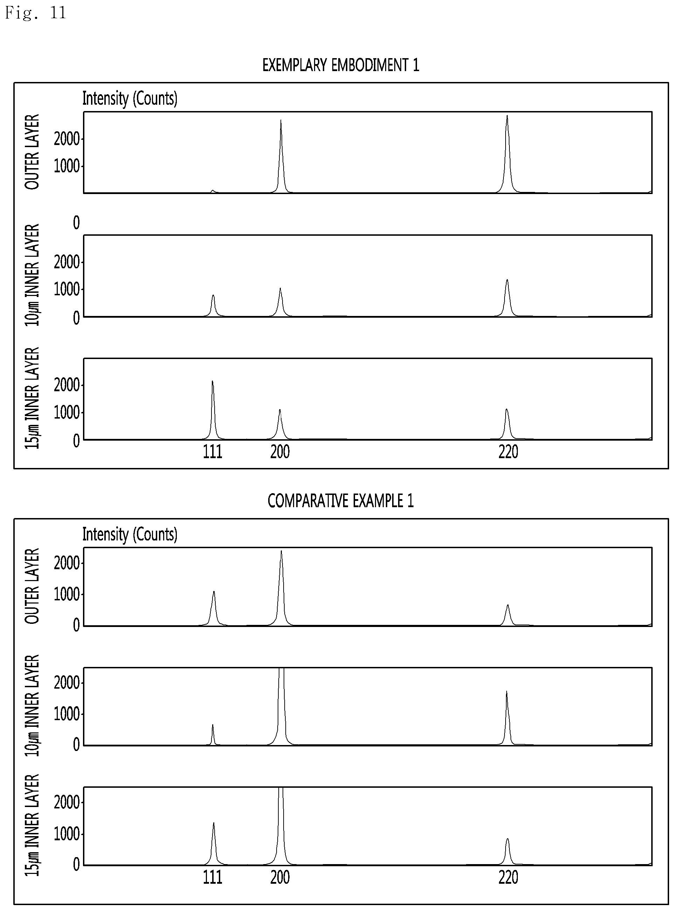

Referring to FIG. 11, since the outer layer of Exemplary Embodiment 1 indicates a strong peak at the {220} crystal plane, it can be seen that the ratio of the {220} crystal plane of the outer layer is greater than that of the {220} crystal plane of the inner layer.

The diffraction intensity of X-rays of the {220} crystal plane of the outer layer of Exemplary Embodiment 1 may be greater than that of the {220} crystal plane of the inner layer located at a region of the depth of 10 $\mu$m from the surface of the invar metal. Specifically, the diffraction intensity of X-rays of the {220} crystal plane of the outer layer of Exemplary Embodiment 1 may be at least two times greater than that of the {220} crystal plane of the inner layer located at a region of the depth of 10 $\mu$m from the surface of the invar metal. For example, specifically, the diffraction intensity of X-rays of the {220} crystal plane of the outer layer of Exemplary Embodiment 1 may be at least 2.1 times greater than that of the {220} crystal plane of the inner layer located at a region of the depth of 10 $\mu$m from the surface of the invar metal. Accordingly, it can be seen that the ratio of the {220} crystal plane of the outer layer of Exemplary Embodiment 1 is greater than that of the {220} crystal plane of the inner layer located at a region of a depth of 10 $\mu$m from the surface of the invar metal.

The diffraction intensity of X-rays of the {220} crystal plane of the outer layer of Exemplary Embodiment 1 is greater than that of the {220} crystal plane of the inner layer located at a region of the depth of 15 $\mu$m from the surface of the invar metal. Specifically, the diffraction intensity of X-rays of the {220} crystal plane of the outer layer of Exemplary Embodiment 1 may be at least two times greater than that of the {220} crystal plane of the inner layer located at a region of the depth of 15 $\mu$m from the surface of the invar metal. For example, specifically, the diffraction intensity of X-rays of the {220} crystal plane of the outer layer of Exemplary Embodiment 1 may be at least 2.2 times greater than that of the {220} crystal plane of the inner layer located at a region of the depth of 15 $\mu$m from the surface of the invar metal. Accordingly, it can be seen that the ratio of the {220} crystal plane of the outer layer of Exemplary Embodiment 1 is greater than that of the {220} crystal plane of the inner layer located at a region of a depth of 15 $\mu$m from the surface of the invar metal.

The diffraction intensity of X-rays of the {220} crystal plane of the inner layer located at a region of the depth of 10 $\mu$m from the surface of the invar metal of Exemplary Embodiment 1 is greater than that of the {220} crystal plane of the inner layer located at a region of the depth of 15 $\mu$m from the surface of the invar metal. Specifically, the diffraction intensity of X-rays of the {220} crystal plane of the inner layer located at a region of the depth of 10 $\mu$m from the surface of the invar metal of Exemplary Embodiment 1 may be at least 1.1 times greater than that of the {220} crystal plane of the inner layer located at a region of the depth of 15 $\mu$m from the surface of the invar metal. Accordingly, it can be seen that the ratio of the {220} crystal plane of the inner layer located at a region of the depth of 10 $\mu$m from the surface of the invar metal of Exemplary Embodiment 1 is greater than that of the {220} crystal plane of the inner layer located at a region of the depth of 15 $\mu$m from the surface of the invar metal.

The ratio of the {220} crystal plane of Exemplary Embodiment 1 may decrease from the outer layer as toward a center of the inner layer. The ratio of the {220} crystal texture of the outer layer to the ratio of the {220} crystal texture of the inner layer of Exemplary Embodiment 1 is more than 1 (The ratio of the {220} crystal texture of the outer layer / the ratio of the {220} crystal texture of the inner layer > 1). Accordingly, in Exemplary Embodiment 1, the etch rate in the outer layer may be reduced compared with that in the inner layer, and thus the etching factor may be improved. In addition, since the ratio of the {220} crystal plane decreases as toward the center of the inner layer from the outer layer, the etching characteristics may be excellent in a thickness direction of the metal plate, that is, a depth direction of the through-hole, and thus the through-hole having a fine size may be formed to have excellent uniformity.

The ratio of the {220} crystal plane of the outer layer according to Exemplary Embodiment 1 may be greater than that of a {111} crystal plane of the outer layer. The ratio of the {220} crystal plane of the outer layer according to Exemplary Embodiment 1 is greater than that of a {200} crystal plane of the outer layer.

The ratio of the diffraction intensity of X-rays of the {220} crystal plane to the ratio of the diffraction intensity of X-rays of the {200} crystal plane of the metal plate, measured in the outer layer according to Exemplary Embodiment 1 is more than 1 ({220} X-ray intensity ratio / {200} X-ray intensity ratio> 1).

The ratio of the {220} crystal plane of the inner layer measured at an inside of 10 $\mu$m from a surface of the metal plate according to Exemplary Embodiment 1 may be greater than the ratio of the {111} crystal plane of the inner layer measured at an inside of 10 $\mu$m from the surface of the metal plate. Further, the ratio of the {220} crystal plane of the inner layer measured at an inside of 10 $\mu$m from the surface of the metal plate according to Exemplary Embodiment 1 may be greater than the ratio of the {200} crystal plane of the inner layer measured at an inside of 10 $\mu$m from the surface of the metal plate.

The ratio of the diffraction intensity of X-rays of the {220} crystal plane to the ratio of the diffraction intensity of X-rays of the {200} crystal plane, measured at the inside of 10 $\mu$m from the surface of the metal plate according to Exemplary Embodiment 1 is more than 1 ({220} X-ray intensity ratio / {200} X-ray intensity ratio> 1).

Meanwhile, since the outer layer of Comparative Example 1 indicates a weaker peak than Exemplary Embodiment 1 in the {220} crystal plane, it can be seen that the ratio of the {220} crystal plane of the outer layer is smaller than that of the inner layer.

The diffraction intensity of X-rays of the {220} crystal plane of the outer layer of Comparative Example 1 may be smaller than that of the {220} crystal plane of the inner layer located at a region of the depth of 10 $\mu$m from the surface of the invar metal. Specifically, the diffraction intensity of X-rays of the {220} crystal plane of the inner layer located at a region of the depth of 10 $\mu$m from the surface of the invar metal of Comparative Example 1 may be at least 2 times greater than that of the {220} crystal plane of the outer layer. For example, the diffraction intensity of X-rays of the {220} crystal plane of the inner layer located at a region of the depth of 10 $\mu$m from the surface of the invar metal of Comparative Example 1 may be at least 2.5 times greater than that of the {220} crystal plane of the outer layer. Accordingly, it can be seen that the ratio of the {220} crystal plane of the outer layer of Comparative Example 1 is smaller than that of the {220} crystal plane of the inner layer located at a region of the depth of 10 $\mu$m from the surface of the invar metal.

The diffraction intensity of X-rays of the {220} crystal plane of the outer layer of Comparative Example 1 may be smaller than that of the {220} crystal plane of the inner layer located at a region of the depth of 15 $\mu$m from the surface of the invar metal. Specifically, the diffraction intensity of X-rays of the {220} crystal plane of the inner layer located at a region of the depth of 15 $\mu$m from the surface of the invar metal of Comparative Example 1 may be at least 1.1 times greater than that of the outer layer. For example, the diffraction intensity of X-ray of the {220} crystal plane of the inner layer located at a region of the depth of 15 $\mu$m from the surface of the invar metal of Comparative Example 1 may be at least 1.2 times greater than that of the {220} crystal plane of the outer layer. Accordingly, it can be seen that the ratio of the {220} crystal plane of the outer layer of Comparative Example 1 is smaller than that of the {220} crystal plane of the inner layer located at a region of the depth of 15 $\mu$m from the surface of the invar metal.

The diffraction intensity of X-rays of the {220} crystal plane of the inner layer located at a region of the depth of 10 $\mu$m from the surface of the invar metal of Comparative Example 1 may be greater than that of the {220} crystal plane of the inner layer located at a region of the depth of 15 $\mu$m from the surface of the invar metal. Specifically, the diffraction intensity of X-rays of the {220} crystal plane of the inner layer located at a region of the depth of 10 $\mu$m from the surface of the invar metal of Comparative Example 1 may be at least 1.5 times greater than that of the {220} crystal plane of the inner layer located at a region of the depth of 15 $\mu$m from the surface of the invar metal. Accordingly, it can be seen that the ratio of the {220} crystal plane of the inner layer located at a region of the depth of 10 $\mu$m from the surface of the invar metal of Comparative Example 1 is greater than that of the {220} crystal plane of the inner layer located at a region of the depth of 15 $\mu$m from the surface of the invar metal.

The ratio of the {220} crystal texture of the outer layer to the ratio of the {220} crystal texture of the inner layer of Comparative Example 1 may be less than 1 (The ratio of the {220} crystal texture of the outer layer / the ratio of the {220} crystal texture of the inner layer < 1). Accordingly, in Comparative Example 1, the etch rate in the outer layer may be faster compared with that in the inner layer, and thus the etching factor may be low and efficiency of OLED deposition may be deteriorated.

The ratio of the {220} crystal plane of the outer layer according to Comparative Example 1 may be smaller than that of the {111} crystal plane of the outer layer. Further, the ratio of the {220} crystal plane of the outer layer according to Comparative Example 1 may be smaller than that of the {200} crystal plane of the outer layer.

The ratio of the diffraction intensity of X-rays of the {220} crystal plane of the metal plate to the ratio of the diffraction intensity of X-rays of the {200} crystal plane thereof, measured in the outer layer according to Comparative Example 1 may be less than 1 ({220} X-ray intensity ratio / {200} X-ray intensity ratio < 1). Specifically, the ratio of the diffraction intensity of X-rays of the {220} crystal plane of the metal plate to the ratio of the diffraction intensity of X-rays of the {200} crystal plane thereof, measured in the outer layer according to Comparative Example 1 may be less than 0.5. For example, the ratio of diffraction intensity of X-rays of the {220} crystal plane of the metal plate to the ratio of the diffraction intensity of X-rays of the {200} crystal plane thereof, measured in the outer layer according to Comparative Example 1 may be 0.1 to 0.4.

The ratio of the {220} crystal plane of the inner layer measured at an inside of 10 $\mu$m from the surface of the metal plate according to Comparative Example 1 may be smaller than the ratio of the {200} crystal plane of the inner layer measured at an inside of 10 $\mu$m from the surface of the metal plate.

The ratio of the diffraction intensity of X-rays of the {220} crystal plane to the ratio of the diffraction intensity of X-rays of the {200} crystal plane, measured at the inside 10 $\mu$m from the surface according to Comparative Example 1 may be less than 1 ({220} X-ray intensity ratio / {200} X-ray intensity ratio < 1).

<Experimental Example 2: Evaluation of etching factor and etch rate>

An opened photoresist layer was formed on each of one surfaces of the rolled invar metal according to Exemplary Embodiment 1 and Comparative Example 1.

Thereafter, a surface hole was formed by an etching process.

The etching process was proceeded on the surface in which the opened photoresist layer was formed. The photoresist layer may include a material capable of maintaining physical/chemical stability in the etching process. Accordingly, the invar metal in which the photoresist layer is disposed may prevent the etching. Meanwhile, as the invar metal located at the open region of the photoresist layer is in contact with the etchant, a surface hole may be formed. One surface hole may be formed at a lower portion of one opened photoresist layer. At this point, the one surface hole may be one of the first surface hole and the second surface hole. A plurality of surface holes may be formed at the lower portions of a plurality of opened photoresist layers simultaneously.

The etching process was performed at 45 °C by a wet etching process, and the etchant contained 36 wt% of $FeCl_3$.

Table 1 below shows the etching factor and etch rate according to Exemplary Embodiment 1 and Comparative Example 1.

The etch rate of the outer layer was measured in the thickness range to a point within 1 $\mu$m from the surface of the rolled invar metal plate.

The etch rate of the inner layer was measured in the range of thickness from the point of 1 $\mu$m to the point of 10 $\mu$m from the surface of the invar metal plate.

[Table 1]

|  | Exemplary Embodiment 1 | Comparative Example 1 |
|---|---|---|
| Etching factor | 2.2 | 1.3 |
| Etch rate of inner layer ($\mu$m/sec) | 0.05 | 0.05 |
| Etch rate of outer layer ($\mu$m/sec) | 0.02 | 0.5 |

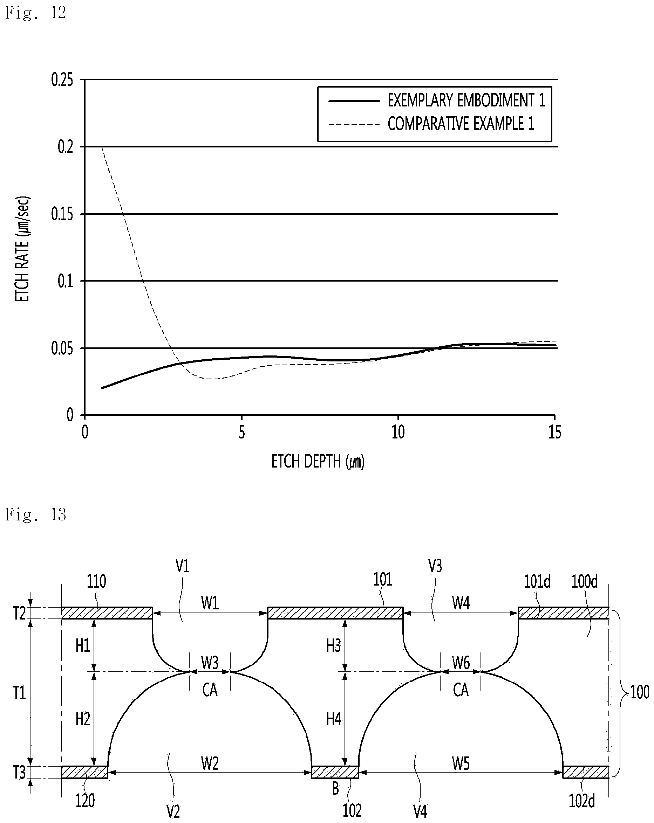

Referring to Table 1 and FIG. 12, after the wet etching process, the etching factor of the surface hole according to Comparative Example 1 calculated by Equation 1 may be less than 2.0. The etching factor of the surface hole according to Comparative Example 1 calculated by Equation 1 may be less than 1.5. Specifically, the etching factor of the surface hole according to Comparative Example 1 was measured to be 1.3. Accordingly, non-uniformity of the etching may occur. In addition, when the etching factor is less than 2.0, a through-hole having a larger size than a desired through-hole may be formed, and thus reproducibility of processing may be deteriorated. Therefore, it may be difficult to form an OLED pattern of a fine size.

In Comparative Example 1, it can be seen that the etch rate of the outer layer is faster than that of the inner layer. That is, in Comparative Example 1, it can be seen that the etch rate at a surface, which has a wide contact area of the etchant, is faster than the etch rate at an inside thereof. Specifically, the etch rate of the outer layer of Comparative Example 1 may be more than 0.03 $\mu$m/sec. More specifically, the etch rate of the outer layer of Comparative Example 1 was measured to be 0.5 $\mu$m/sec.

Meanwhile, referring to Table 1 and FIG. 12, after the wet etching process, the etching factor of the surface hole according to Exemplary Embodiment 1 calculated by Equation 1 may be more than or equal to 2.0. The etching factor of the surface hole according to Exemplary Embodiment 1 calculated by Equation 1 may be 2.0 to 2.5. Specifically, the etching factor of the surface hole according to Exemplary Embodiment 1 was measured to be 2.2. Accordingly, uniformity of a plurality of through-holes may be improved. When the etching factor is more than 2.0, reproducibility of processing may be ensured and a through-hole having a fine size may be formed. Therefore, it is possible to form an OLED pattern of a fine size.

In Exemplary Embodiment 1, it can be seen that the etch rate of the inner layer is faster than that of the outer layer. Specifically, the etch rate of the outer layer of Exemplary Embodiment 1 may be less than or equal to 0.03 $\mu$m/sec. More specifically, the etch rate of the outer layer of Exemplary Embodiment 1 was measured to be 0.02 $\mu$m/sec. The etch rate of the inner layer according to Exemplary Embodiment 1 may be 0.03 to 0.05 $\mu$m/sec. The etch rate of the inner layer of Exemplary Embodiment 1 was measured to be 0.05 $\mu$m/sec.

That is, in Exemplary Embodiment 1, a crystal texture having a high ratio of the {220} crystal plane in a region of a thickness range of less than or equal to 1 $\mu$m from the surface of the metal plate may be formed by rolling. Accordingly, the etch rate at the surface of the metal plate, that is, the outer layer, may be slower than that of the inner layer. Therefore, the metal plate according to Exemplary Embodiment 1 may form a fine through-hole. For example, the outer layer may include surface layers 110 and 120 defined by a thickness range of 15 to 30 nm from the surface of the metal plate. For example, the outer layer may include surface layers 110 and 120 defined by a thickness range of 15 to 25 nm from the surface of the metal plate.

Then, referring to FIGS. 13 to 18, a metal plate according to the second embodiment will be described.

The second embodiment is firstly directed to reducing the etch rate at a surface of the metal plate 100.

The second embodiment may include a surface layer defined by a thickness range of 10 to 30 nm from the surface of the metal plate. The surface layer may have a higher oxygen content than a metal layer other than the surface layer. Accordingly, the etch rate on the first and second surfaces of the metal plate may be slow. That is, an second embodiment may reduce the etch rate in the initial stage of the etching, thereby preventing the photoresist layer from being de-filmed or separated. Accordingly, the second embodiment may improve uniformity of through-holes and form a fine through-hole, and thus a manufacturing yield of the through-hole and process efficiency may be improved.

The second embodiment in the etching process is secondarily directed that an etching factor of a surface hole is more than or equal to 2.0.

In the second embodiment, since the etching factor of the surface hole is more than or equal to 2.0, the etching characteristics may be excellent, and an uniform through-hole having a fine size may be formed.

Referring to FIG. 13, the metal plate 100 used for manufacturing the mask for deposition includes an outer layer defined by the thickness range of less than or equal to 1 $\mu$m from the surface of the metal plate; and an inner layer other than the outer layer.

The outer layer may include surface layers 110 and 120 defined by the thickness range of 10 to 30 nm from the surface of the metal plate.

The metal plate according to the second embodiment may include a first surface 101 and a second surface 102 facing the first surface, and the surface layer may include a first surface layer 110 defined by the thickness range of 10 to 30 nm from the first surface 101 and a second surface layer 120 defined by the thickness range of 10 to 30 nm from the second surface 102.

The metal plate according to the second embodiment may include a surface layer and a base metal plate 100d, which is a metal plate other than the surface layer.

For example, the metal plate 100 may include the base metal plate 100d, a first surface layer 110 disposed on a first surface 101d of the base metal plate 100d, and a second surface layer 120 disposed on a second surface 102d of the base metal plate 100d facing the first surface 101.

A thickness of the base metal plate 100d may be greater than that of the surface layer. For example, a thickness T1 of the base metal plate 100d may be greater than a thickness T2 of the first surface layer 110 and a thickness T3 of the second surface layer 120.

The thickness of the metal plate 100 may be 10 to 50 $\mu$m. For example, the thickness of the metal plate 100 may be 10 to 30 $\mu$m. When the thickness of the metal plate 100 is less than 10 $\mu$m, manufacturing efficiency may be low.

When the thickness of the metal plate 100 is more than 50 $\mu$m, process efficiency for forming a through-hole may be deteriorated.

The thickness T1 of the base metal plate 100d may be less than or equal to 50 $\mu$m. For example, the thickness T1 of the base metal plate 100d may be less than or equal to 30 $\mu$m.

The first surface layer 110 and the second surface layer 120 may have a thickness corresponding to each other. Here, the "corresponding" may include an error due to tolerance.

The thickness T2 of the first surface layer 110 may be 10 to 30 nm. For example, the thickness T2 of the first surface layer 110 may be 10 to 20 nm.

When the thickness T2 of the first surface layer 110 is less than 10 nm, the effect of lowering the etch rate on the first surface 101 may be reduced, and thus uniformity of the through-hole may be deteriorated.

For example, when the thickness T2 of the first surface layer 110 is less than 10 nm, a through-hole having a large variation in thickness and/or width is formed, so that the pattern formed by the metal plate having the through-hole may not be uniform, and thus manufacturing efficiency of the display device may be deteriorated.

In addition, when the thickness T2 of the first surface layer 110 is less than 10 nm, the effect of lowering the etch rate on the first surface 101 may be reduced, and thus it is difficult to form a through-hole having a fine size.

In addition, when the thickness T2 of the first surface layer 110 is less than 10 nm, the surface roughness of an inner circumferential surface of the first surface hole V1 increases, so that quality of the deposition pattern formed through the first surface hole V1 may be degraded, and thus process efficiency may be deteriorated.

Meanwhile, when the thickness T2 of the first surface layer 110 is more than 30 nm, the manufacturing efficiency may be deteriorated.

The thickness T3 of the second surface layer 120 may be 10 to 30 nm. For example, the thickness T3 of the second surface layer 120 may be 10 to 20 nm. When the thickness T3 of the second surface layer 120 is less than 10 nm, the effect of lowering the etch rate on the second surface 102 may be reduced, and thus uniformity of the through-hole may be deteriorated. For example, when the thickness T3 of the second surface layer 120 is less than 10 nm, a through-hole having a large variation in thickness and/or width is formed, so that the pattern formed by the metal plate having the through-hole may not be uniform, and thus manufacturing efficiency of the display device may be deteriorated.

In addition, when the thickness T3 of the second surface layer 120 is less than 10 nm, the effect of lowering the etch rate on the second surface 102 may be reduced, and thus it is difficult to form a through-hole having a fine size.

In addition, when the thickness T3 of the second surface layer 120 is less than 10 nm, the surface roughness of an inner circumferential surface of the second surface hole V2 may be increased.

Meanwhile, when the thickness T3 of the second surface layer 120 is more than 30 nm, the manufacturing efficiency may be deteriorated.

The base metal plate 100d includes invar including about 35 to 37 wt% of nickel, about 63 to 65 wt% of iron, and at least one of a trace amount of C, Si, S, P, Cr, Mo, Mn, Ti, Co, Cu, Fe, Ag, Nb, V, In, and Sb.

The base metal plate 100d may have different compositions of elements included in the first surface layer 110. In addition, the base metal plate 100d may have different compositions of elements included in the second surface layer 120.

For example, the first surface layer 110 and the second surface layer 120 may include an oxygen element. The first surface layer 110 and the second surface layer 120 may be metal oxide films. Thicknesses of the first surface layer 110 and the second surface layer 120 may be determined according to a surface treatment time under oxygen-injected sputtering conditions.

A content of oxygen in the surface layer may be higher than that of oxygen in the outer layer other than the surface layer. In addition, the content of oxygen in the surface layer may be higher than that of oxygen in the inner layer.

The content of oxygen in the first surface layer 110 may be higher than that of oxygen in the base metal plate 100d. The content of oxygen in the second surface layer 120 may be higher than that of oxygen in the base metal plate 100d. That is, the surface layer may be an oxygen layer including oxygen. Here, the oxygen layer may have an oxygen content of more than or equal to 1 wt%. Alternatively, the oxygen layer may have an oxygen content of more than or equal to 0.1 wt%. Alternatively, the oxygen layer may have an oxygen content of more than or equal to 0.01 wt%. However, an embodiment is not limited thereto, and the surface layer may not include oxygen. Here, absence of oxygen may mean that oxygen is less than or equal to 0.001 wt%. Here, absence of oxygen may mean that oxygen is less than or equal to 0 wt%.

In the metal plate according to the second embodiment, X-ray photoelectron spectroscopy (XPS) is used to measure an oxygen content of the first surface layer 110 and the second surface layer 120, which is greater than that of the base metal plate 100d.

The oxygen content of the first and second surface layers 110 and 120 was measured to be higher than that of the base metal plate 100d via the X-ray photoelectron spectroscopy.

The high content of oxygen in the first surface layer 110 measured by the X-ray photoelectron spectroscopy was remarkably decreased from the first surface 101d of the base metal plate 100d as a starting point. In addition, the high content of oxygen in the second surface layer 120 measured by the X-ray photoelectron spectroscopy was remarkably decreased from the second surface 102d of the base metal plate 100d as a starting point.

The first surface layer 110 and the second surface layer 120 may include at least one of a metal oxide and a metal hydroxide. For example, the first surface layer 110 and the second surface layer 120 may include iron oxide and nickel oxide as metal oxides. For example, the first surface layer 110 and the second surface layer 120 may include iron hydroxide and nickel hydroxide as metal hydroxides. Specifically, the first surface layer 110 may include at least one of $FeO$, $NiO$, $FeOH$, $NiOH$, $Fe(OH)_2$, $Fe(OH)_3$, $NiO_2$, $NiO_3$, $Ni_nO_m$, $Fe_nO_m$, $Ni_n(OH)_m$ and $Fe_n(OH)_m$. n and m may be integers of more than or equal to 1, respectively, in $Ni_nO_m$, $Fe_nO_m$, $Ni_n(OH)_m$, and $Fe_n(OH)_m$. Further, the second surface layer 120 may include at least one of $FeO$, $NiO$, $FeOH$, $NiOH$, $Fe(OH)_2$, $Fe(OH)_3$, $NiO_2$, $NiO_3$, $Ni_nO_m$, $Fe_nO_m$, $Ni_n(OH)_m$ and $Fe_n(OH)_m$. n and m may be integers of more than or equal to 1, respectively, in $Ni_nO_m$, $Fe_nO_m$, $Ni_n(OH)_m$, and $Fe_n(OH)_m$.

The etch rate of the first surface layer 110 may be slower than that of the base metal plate 100d. The etch rate of the second surface layer 120 may be slower than that of the base metal plate 100d.

In the second embodiment, the first surface layer may be disposed on the first surface 101d of the base metal plate 100d and the second surface layer may be disposed on the second surface 102d of the base metal plate 100d, and thus the etch rate at the surface of the metal plate may be reduced.

The first surface layer 110 and the second surface layer 120 may include an oxygen element so that the etch rate may be slower than that of the base metal plate 100d. In addition, in an embodiment, the first surface layer 110 and the second surface layer 120 are disposed on the base metal plate 100d at a thickness of 10 to 30 nm, respectively, thereby forming a fine through-hole.

For example, in the metal plate according to an embodiment, when the first surface layer 110 and the second surface layer 120 are disposed at a thickness of 10 to 30 nm, respectively, the width W1 of the first surface hole V1 may correspond to the width W4 of the third surface hole V3, and the width W2 of the second surface hole V2 may correspond to the width W5 of the fourth surface hole V4. For example, in the metal plate according to an embodiment, when the first surface layer 110 and the second surface layer 120 are disposed at a thickness of 10 to 30 nm, respectively, the height H1 of the first surface hole V1 may correspond to the height H3 of the third surface hole V3, and the height H2 of the second surface hole V2 may correspond to the height H4 of the fourth surface hole V4. That is, uniformity of the width and height of the plurality of through-holes may be improved.

That is, the metal plate according to an embodiment may have a slow etch rate in a region in which the first surface layer 110 and the second surface layer 120 are disposed, so that it is possible to form the through-hole with a small width and a deep thickness. Accordingly, it possible to prevent a de-filming phenomenon of the photoresist layer from being caused by a rapid etching at a metal surface.

In addition, the metal plate used for manufacturing the mask for deposition according to an embodiment may control the etch rate at the surface, and thus the metal plate may improve a manufacturing yield of the through-hole having a fine pattern and uniformity of the plurality of through-holes may improved. Accordingly, the OLED panel manufactured by using such a mask for deposition has excellent deposition efficiency of the pattern and may improve deposition uniformity. In addition, the surface layer according to an embodiment includes at least one of a metal oxide and a metal hydrate, so that an adhesion force of the photoresist layer may be improved, and thus the photoresist layer may be prevented from being de-filmed or separated in the etching process. Specifically, an adhesion force between a ceramic-based surface layer and the photoresist layer may be greater than an adhesion force between the metal layer and the photoresist layer. Accordingly, the metal plate according to an embodiment may improve a manufacturing yield and process efficiency of the plurality of through-holes.

In the metal plate used for manufacturing the mask for deposition according to the second embodiment, the inner layer and the outer layer may have different etch rates.

For example, the etch rate of the outer layer may be less than or equal to 0.03 $\mu$m/sec. For example, the etch rate of the outer layer may be less than or equal to 0.01 to 0.03 $\mu$m/sec. For example, the etch rate of the outer layer may be less than or equal to 0.02 to 0.03 $\mu$m/sec.

For example, the etch rate of the inner layer may be 0.03 to 0.06 $\mu$m/sec. For example, the etch rate of the inner layer may be 0.03 to 0.05 $\mu$m/sec.

That is, the metal plate used for manufacturing the mask for deposition according to an embodiment may have an etch rate of the outer layer slower than that of the inner layer, so that the etching characteristics of the through-holes may be excellent. In addition, the OLED panel manufactured by using the mask for deposition according to an embodiment has excellent deposition efficiency of the pattern and may improve deposition uniformity.

The width of the through-hole may be more than or equal to 20 $\mu$m. For example, the width of the through-hole may be 20 to 40 $\mu$m. For example, at least one of the width W1 of the first surface hole and the width W2 of the second surface hole may have a width of more than or equal to 20 $\mu$m. For example, at least one of the width W1 of the first surface hole and the width W2 of the second surface hole may have a width of 20 to 40 $\mu$m.

When the width of the through-hole is less than 20 $\mu$m, an effect of reducing the etch rate by the surface layer before and after heat treatment may be small.

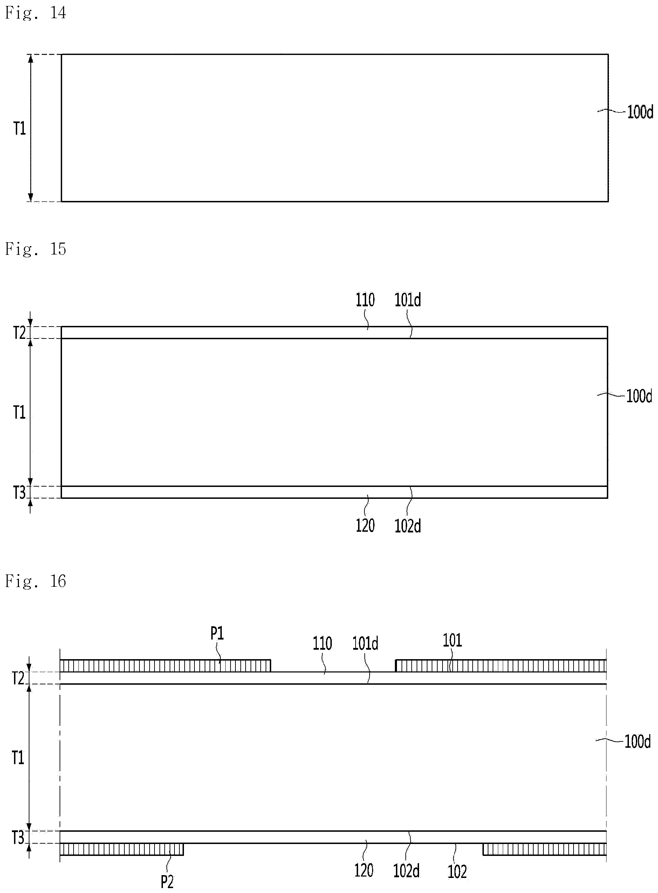

Referring to FIGS. 14 to 18, a manufacturing process of a mask for deposition according to the second embodiment will be described.

A manufacturing method of a mask for deposition according to the second embodiment may include: preparing a base metal plate; rolling the base metal plate; forming a surface layer to dispose a first surface layer on a first surface of the base metal plate, and dispose a second surface layer on a second surface of the base metal plate; forming a photoresist layer to dispose a first photoresist layer on the first surface of the base metal plate and dispose a second photoresist layer on a second surface; and etching to form a through-hole through which a first surface hole of the first surface and a second surface hole of the second surface communicate with each other.

Then, the mask for deposition including a plurality of through-holes may be formed by removing the first and second photoresist layers.

First, the preparing of a base metal plate will be described. The base metal plate is invar including about 35 to 37 wt% of nickel, about 63 to 65 wt% of iron, and at least one of a trace amount of C, Si, S, P, Cr, Mo, Mn, Ti, Co, Cu, Fe, Ag, Nb, V, In, and Sb.

Then, the rolling of the base metal plate will be described with reference to FIG. 14. The rolled base metal plate 100d may have a thickness T1 of less than or equal to 50 $\mu$m. For example, the rolled base metal plate 100d may have a thickness T1 of less than or equal to 30 $\mu$m.

Then, the forming of a surface layer will be described with reference to FIG. 15. Referring to FIG. 15, a surface layer may be formed on the base metal plate 100d. For example, the base metal plate 100d may be heat-treated, so that a surface layer may be formed on the base metal plate 100d. Specifically, the base metal plate 100d may be heat-treated under an oxygen atmosphere, so that the first surface layer 110 may be formed on the first surface 101 d of the base metal plate 100d, and the second surface layer 120 may be formed on the second surface 102d of the base metal plate 100d. For example, the first surface layer 110 and the second surface layer 120 may be simultaneously formed by the heat treatment process, thereby improving process efficiency. In addition, the first surface layer 110 and the second surface layer 120 may be disposed on the base metal plate 100d at a thickness corresponding to each other, so that the etch rate of the first surface 101 and the second surface 102 of the base metal plate 100d may be deteriorated. However, the embodiment is not limited thereto, and the surface layer may obviously be formed by anodizing, plasma treatment, or the like.

Then, the forming of a photoresist layer will be described with reference to FIG. 16. A first photoresist layer P1 may be disposed on the first surface 101d of the base metal plate 100d and a second photoresist layer P2 may be formed on the second surface 102d thereof. Specifically, a first photoresist layer P1 may be disposed on the first surface layer 110 and a second photoresist layer P2 may be disposed on the second surface layer 120. More specifically, a photoresist material may be coated on the first surface layer 110 and the second surface layer 120, respectively and the first photoresist layer P1 and the second photoresist layer P2 may be disposed by an exposure and development process, respectively.

The first photoresist layer P1 and the second photoresist layer P2 are disposed such that widths of open regions are different from each other, so that the width of the first surface hole V1 formed on the first surface 101 and the width of the second surface hole V2 formed on the second surface 102 may be different.

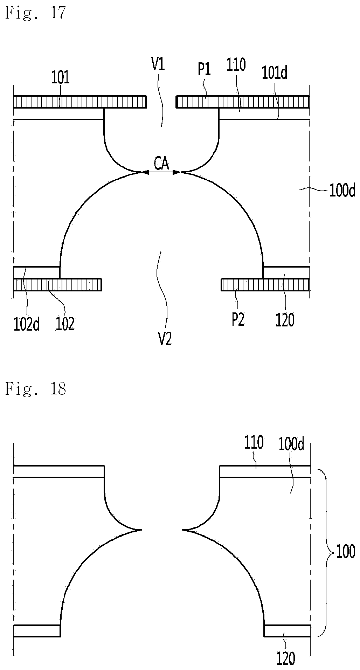

Then, referring to FIG. 17, the etching will be described. In the etching process, the first surface hole V1 and the second surface hole V2 may be formed and a through-hole may be formed as the first surface hole V1 and the second surface hole V2 communicate with each other by the connecting part CA.

For example, the etching process may be performed by a wet etching process. Accordingly, the first surface 101 and the second surface 102 may be simultaneously etched. For example, the wet etching process may be performed at about 45 °C by using an etchant containing iron chloride. At this point, the etchant may contain 35 to 45 wt% of $FeCl_3$. Specifically, the etchant may contain 36 wt% of $FeCl_3$. For example, specific gravity of the etchant containing 43 wt% of $FeCl_3$ may be 1.47 at 20 °C. The specific gravity of the etchant containing 41 wt% of $FeCl_3$ may be 1.44 at 20 °C. The specific gravity of the etchant containing 38 wt% of $FeCl_3$ may be 1.39 at 20 °C.

After the etching, the etching factor of at least one of the first and second surface holes calculated by Equation 1 may be more than or equal to 2.0.

Then, referring to FIG. 18, the first photoresist layer P1 and the second photoresist layer P2 may be removed so that a first surface layer 110 and a second surface layer 120 may be disposed on the base metal plate 100d and the metal plate having a plurality of through-holes may be formed.

Hereinafter, the second embodiment will be described in more detail with reference to exemplary embodiments and comparative examples. Such an embodiment is merely an example in order to explain the present invention in more detail. Therefore, the present invention is not limited to such an embodiment.

<Experimental Example 3: Evaluation of uniformity and roughness of through-hole>

Exemplary Embodiment 2

A surface layer of 20 nm was formed on rolled invar metal, and then a surface was formed via an etching process.
At this point, the etching process was performed at 45 °C by a wet etching process, and an etchant contained 36 wt% of $FeCl_3$.

Comparative Example 2

A surface layer of 5 nm was formed on rolled invar metal, and then a surface hole was formed by an etching process.
At this point, rolling conditions of the invar metal, a thickness of the invar metal, and an etching process were proceeded under the same conditions as in Exemplary Embodiment 2.

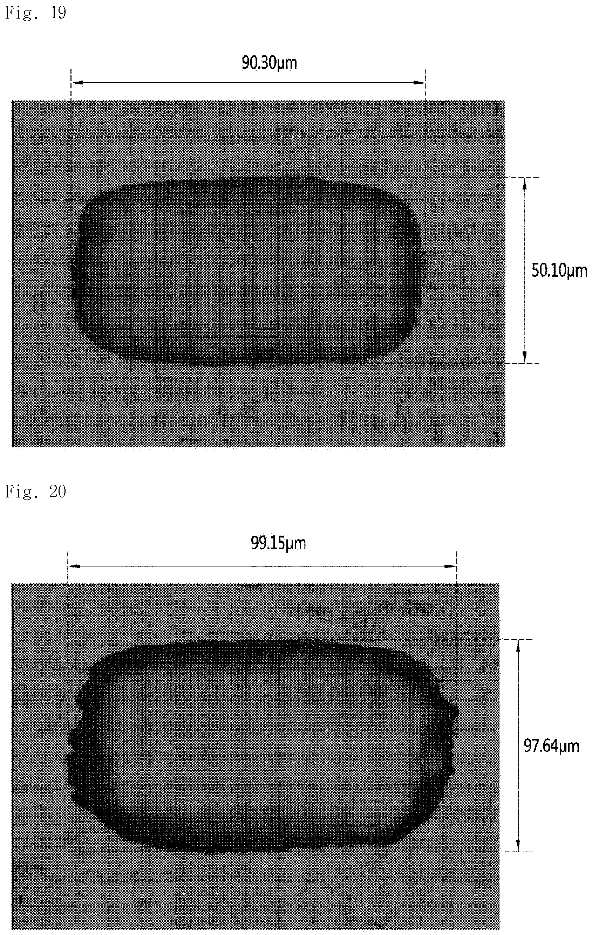

FIGS. 19 and 20 are photographs of through-holes formed according to Exemplary Embodiment 2 and Comparative Example 2.
Referring to FIG. 19, it can be seen that the through-hole formed according to Exemplary Embodiment 2 has a low surface roughness of the through-hole. That is, the inner circumferential surface of the through-hole may be a smooth curved line, and uniformity of the pattern shape deposited through the same may be improved.
Meanwhile, referring to FIG. 20, it can be seen that the through-hole formed according to Comparative Example 2 has a large surface roughness of the through-hole. That is, the inner circumferential surface of the through-hole may include a rugged shape, so that the uniformity of the pattern shape deposited through the through-hole may be reduced.
According to Exemplary Embodiment 2 and Comparative Example 2, it was confirmed that uniformity of through-hole was improved when the thickness of the surface layer was more than or equal to 10 nm.

<Experimental Example 4: Measurement of concentration of oxygen and ratio of crystal plane>

Exemplary Embodiment 3

A surface layer was formed on rolled invar metal.
The surface layer was formed by heat treatment for a predetermined period of time.
Then, a surface hole was formed by an etching process.

Exemplary Embodiment 4

A surface layer was formed on rolled invar metal.
The surface layer of exemplary embodiment 3 was formed such that the heat treatment temperature and/or the heat treatment time were different from that of the surface layer of exemplary embodiment 4.
Then, a surface hole was formed by an etching process.
A thickness of the surface layer of Exemplary Embodiment 4 may be smaller than that of the surface layer of Exemplary Embodiment 3.
At this point, rolling conditions of the invar metal, a thickness of the invar metal, and an etching process were proceeded under the same conditions as in Exemplary Embodiment 3.

Comparative Example 3

A surface layer was not formed on rolled invar metal, and a surface hole was formed by an etching process.
At this point, rolling conditions of the invar metal, a thickness of the invar metal, and an etching process were proceeded under the same conditions as in Exemplary Embodiment 3.
In order to measure the concentration of oxygen, the metal surfaces of Exemplary Embodiments 3 and 4 and Comparative Example 3 were measured by XPS analysis. XPS was applied at 15 kV, 100 $\mu$m (X-ray beam size), and Ar sputter was measured under the condition of 2 kV $2x2$ mm$^2$, 10 min. The concentration of oxygen was measured in the thickness range of 0 to 100 nm at the metal surface. At this point, the oxygen concentration of 597.10 was measured in Exemplary Embodiment 3, the oxygen concentration of 313.75 was measured in Exemplary Embodiment 4, and the oxygen concentration of 233.08 was measured in Comparative Example 3. When binding energy was 1000 eV, a counter shot value of oxygen was measured to be more than $3.0 \times 10^4$.

In Exemplary Embodiments 3 and 4, the oxygen content of the outer layer may be greater than that of the inner layer. In Exemplary Embodiments 3 and 4, the oxygen content of the surface layer may be greater than that of the base metal plate, which is the metal plate other than the surface layer.

In Exemplary Embodiments 3 and 4, it was confirmed that the concentration of oxygen in the surface layer was greater than that of iron. The first surface layer 110 and the second surface layer 120 may have a larger oxygen content than a metal content. For example, an oxygen content (at%) of the first surface layer 110 and the second surface layer 120 may be greater than an iron content (at%). For example, an oxygen content (at%) of the first surface layer 110 and the second surface layer 120 may be greater than a nickel content (at%). For example, an oxygen content (at%) of the first surface layer 110 and the second surface layer 120 may be more than or equal to 30 at%. For example, an oxygen content (at%) of the first surface layer 110 and the second surface layer 120 may be more than or equal to 50 at%.

Meanwhile, XRD analysis was performed to measure a ratio of a crystal plane.

The outer layer of the metal plate according to the second embodiment may include 50% to 70% of the {220} crystal plane. For example, the outer layer of the metal plate according to the second embodiment may include 55% to 70% of the {220} crystal plane.

In the outer layer having a thickness of 1 $\mu$m from a surface of the metal plate of Exemplary Embodiment 3, the {220} crystal plane was measured to be 58.1%, the {200} crystal plane was 40.8%, and the {111} crystal plane was 1.0%. In the inner layer having a thickness range of 10 $\mu$m from a thickness region of 1 $\mu$m of the metal plate of Exemplary Embodiment 3, the {220} crystal plane was measured to be 24.6%, the {200} crystal plane was 30.3%, and the {111} crystal plane was 45.1%.

In the outer layer having a thickness of 1 $\mu$m from a surface of the metal plate of Exemplary Embodiment 4, the {220} crystal plane was measured to be 68.9%, the {200} crystal plane was 28.0%, and the {111} crystal plane was 3.1%.

In the outer layer having a thickness of 1 $\mu$m from a surface of the metal plate of Comparative Example 3, the {220} crystal plane was measured to be 27.2%, the {200} crystal plane was 67.3%, and the {111} crystal plane was 5.5%. In the inner layer having a thickness range of 10 $\mu$m from a thickness region of 1 $\mu$m of the metal plate of Comparative Example 3, the {220} crystal plane was measured to be 13.2%, the {200} crystal plane was 64.8%, and the {111} crystal plane was 22%.

Therefore, it can be seen that when the {220} crystal plane included in the outer layer is more than 70%, the etching factor is deteriorated. In addition, when the {220} crystal plane included in the outer layer is less than 50%, it can be seen that the etching factor is deteriorated.

<Experimental Example 5: Evaluation of etching factor and etch rate>

Although not shown in Table 2, in the second embodiment, an etching factor and an etch rate in various ranges were measured by changing formation conditions of the surface layer.

At this point, it was confirmed that an optimum thickness of the surface layer in which the etching characteristics were improved by changing a heat treatment temperature and a heat treatment time was 10 to 30 nm.

In general, a metal plate for manufacturing a mask for deposition includes a surface layer of about 5 nm. However, in an embodiment, in order to improve etching characteristics of the metal plate, the surface layer was formed at a thickness of 10 to 30 nm.

Further, the etching factor and etch rate in various ranges were measured when a surface hole having a diameter of 20 $\mu$m in a horizontal direction and a diameter of 20 $\mu$m in a vertical direction and a surface hole having a diameter of 25 $\mu$m in the horizontal direction and a diameter of 25 $\mu$m in the vertical direction were formed, respectively.

At this point, the etching factor of the mask for deposition may be 2.0 to 2.9. For example, in the second embodiment, the etching factor of the mask for deposition may be 2.0 to 2.5. When the etching factor of the mask for deposition was 2.0 to 2.9, it was confirmed that a fine hole of uniform size was formed due to excellent etching characteristics in the thickness direction of the metal plate.

Table 2 below shows the etching factor and etch rate according to Exemplary Embodiments 3 and 4 and Comparative Example 3.

[Table 2]

| | Exemplary Embodiment 3 | Exemplary Embodiment 4 | Comparative Example 3 |
|---|---|---|---|
| Etching factor | 2.12 | 2.00 | 1.34 |
| Etch rate of inner layer ($\mu$m/sec) | 0.05 | 0.05 | 0.05 |

(continued)

|  | Exemplary Embodiment 3 | Exemplary Embodiment 4 | Comparative Example 3 |
|---|---|---|---|
| Etch rate of outer layer ($\mu$m/sec) | 0.02 | 0.03 | 0.1 |

In Table 2, the etch rate of the outer layer indicates an etch rate observed at a thickness of less than or equal to 1 $\mu$m from the surface of the metal plate. In Table 2, the etch rate of the inner layer indicates an etch rate observed from a thickness of 1 $\mu$m to a thickness of 10 $\mu$m from the surface of the metal plate.

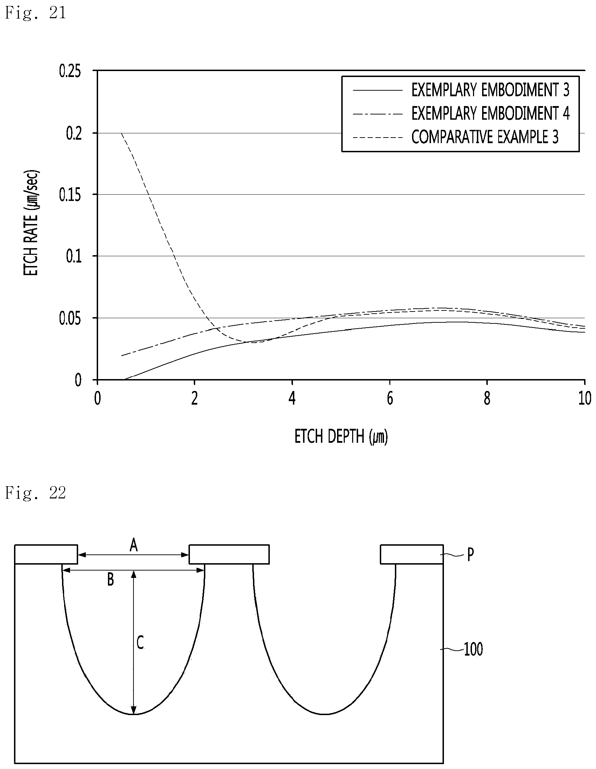

Referring to Table 2 and FIG. 21, it can be seen that the etch rate of the outer layer is faster than that of the inner layer. In Comparative Example 3, the etch rate of the outer layer was measured to be 2 times faster than that of the inner layer. That is, in Comparative Example 3, the etch rate at a surface, which has a wide contact area of the etchant, is faster than the etch rate at an inside thereof. Specifically, the etch rate of the outer layer of Comparative Example 3 may be more than 0.03 um/sec. More specifically, the etch rate of the outer layer of Comparative Example 3 was measured to be 0.1 um/sec.

Referring to FIG. 21, the etch rate is maximized within a depth of 10 $\mu$m from the surface of the metal plate. Specifically, the inner layer between 6 and 8 $\mu$m from the surface of the metal plate may have a maximum etch rate.

On the other hand, in Exemplary Embodiments 3 and 4, it can be seen that the etch rate of the inner layer is faster than that of the outer layer. That is, in Exemplary Embodiments 3 and 4, the surface layer including oxygen element may be disposed on the metal layer, so that the etch rate at the surface of the metal plate may be slower than that in the metal plate. Accordingly, the metal plate according to an embodiment may form a fine through-hole. Specifically, the etch rate of the outer layer of Exemplary Embodiments 3 and 4 may be less than or equal to 0.03 $\mu$m/sec. More specifically, the etch rate of the outer layer of Exemplary Embodiment 3 was measured to be 0.02 $\mu$m/sec, and the etch rate of the outer layer of Exemplary Embodiment 4 was measured to be 0.03 $\mu$m/sec.

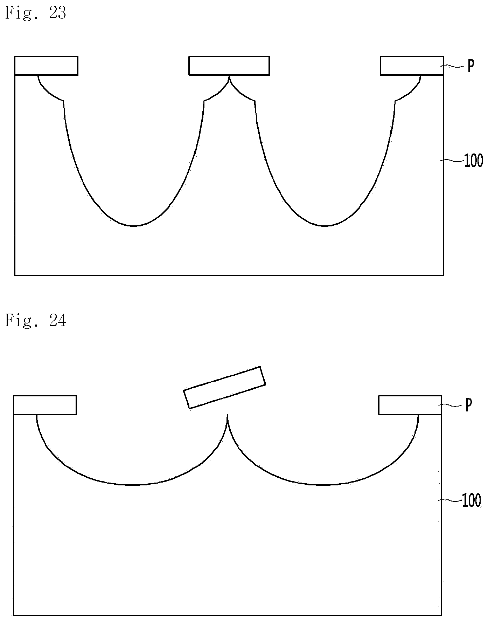

FIG. 22 is a sectional view of a surface hole according to Exemplary Embodiment 3, and FIG. 23 is a sectional view of a surface hole according to Exemplary Embodiment 4.

Referring to FIGS. 22 and 23, it can be seen that Exemplary Embodiments 3 and 4 have a high etching factor of more than or equal to 2.0, so that the width of the through-hole is small and the etching characteristics are excellent in the depth direction. Accordingly, deformation of the photoresist layer may be prevented. In addition, the pattern capable of being formed through the metal plate according to Exemplary Embodiments 3 and 4 may implement a fine pattern.

Referring to FIG. 24, it can be seen that, in the Comparative Example 3, a phenomenon of de-filing of the photoresist layer occurs due to the overlapping of adjacent surface holes. Accordingly, when the etching factor is less than 2.0, it can be seen that the manufacturing yield of the through-hole and process efficiency are deteriorated.

In the mask for deposition according to the second embodiment, the metal plate may include a base metal plate including first and second surfaces facing each other, a first surface layer disposed on the first surface, and a second surface layer disposed on the second surface, wherein the metal plate may include a plurality of through-holes, the first surface layer and the second surface layer may be opened at a region in which the through-holes are disposed, the first surface layer and the second surface layer may have a thickness of 10 to 30 nm, respectively, a thickness of the metal plate may be less than or equal to 50 um, and the etching factor of at least one of the first surface hole and the second surface hole may be more than or equal to 2.0.

In the mask for deposition according to the second embodiment, the surface layer may be disposed on the base metal plate before the through-hole is formed. Accordingly, the surface layer may be opened without being disposed on the region in which the through-hole is disposed.

The inner region of the through-hole may have a different composition of elements included in the surface layer. For example, the content of oxygen in the first surface layer may be higher than that contained in the connecting part of the through-hole. For example, the content of oxygen in the second surface layer may be higher than that contained in the connecting part of the through-hole.

That is, the mask for deposition according to the second embodiment may have a structural feature that the etch rate is gradually increased as it goes from the outer layer toward the inner layer in the etching process for forming the through-holes, and thus etching efficiency and uniformity of the through-hole may be improved.

In addition, the OLED panel manufactured by using the mask for deposition according to an embodiment has excellent deposition efficiency of the pattern and may improve deposition uniformity.

The characteristics, structures, effects, and the like described in the above-described embodiments are included in at least one embodiment of the present invention, but are not limited to only one embodiment. Furthermore, the characteristic, structure, and effect illustrated in each embodiment may be combined or modified for other embodiments by a person skilled in the art. Accordingly, it is to be understood that such combination and modification are included in the scope of the present invention.

The above description of the embodiments is merely examples and does not limit the present invention. It would be apparent to those of ordinary skill in the art that the present invention may be easily embodied in many different forms without changing the technical idea or essential features thereof. For example, elements of the exemplary embodiments described herein may be modified and realized. Also, it should be construed that differences related to such changes and applications are included in the scope of the present invention defined in the appended claims.

**Claims**

1. A metal plate (100) used for manufacturing a mask for deposition, the metal plate (100) comprising:

   an outer layer (100b, 100c) defined by a thickness range of less than or equal to 1 $\mu$m and higher to 0 $\mu$m from a surface of the metal plate (100); and
   an inner layer (100a) other than the outer layer (100b, 100c),
   the outer layer (100b, 100c) and the inner layer (100a) including invar,
   the metal plate (100) comprising two or more crystal planes having different orientations from each other,
   wherein a ratio of a {220} crystal plane of the outer layer (100b, 100c) is greater than that of a {220} crystal plane of the inner layer (100a).

2. The metal plate (100) of claim 1, wherein the outer layer (100b, 100c) includes a {220} crystal plane, a {200} crystal plane and a {111} crystal plane,
   wherein a ratio of the {220} crystal plane of the outer layer (100b, 100c) is 50% to 70%.

3. The metal plate (100) of claim 1, wherein diffraction intensity of X-rays of a {200} crystal plane of the outer layer (100b, 100c) is greater than that of a {200} crystal plane of the inner layer (100a) measured at an inside of 10 $\mu$m from the surface of the metal plate (100).

4. The metal plate (100) of claim 1, wherein the ratio of the {220} crystal plane of the inner layer (100a) measured at an inside of 10 $\mu$m from the surface of the metal plate (100) is greater than that of a {111} crystal plane of the inner layer (100a) measured at an inside of 10 $\mu$m from the surface of the metal plate (100).

5. The metal plate (100) of claim 1, wherein the outer layer (100b, 100c) includes a surface layer (110, 120) having a thickness of 10 to 30 nm from the surface of the metal plate (100),
   wherein the surface layer (110, 120) includes at least one of a metal oxide and a metal hydroxide.

6. The metal plate (100) of claim 5, wherein the surface layer (110, 120) includes oxygen at more than or equal to 0.1 wt%.

7. The metal plate (100) of claim 5, wherein the surface layer (110, 120) includes at least one of FeO, NiO, FeOH, NiOH, $Fe(OH)_2$, $Fe(OH)_3$, $NiO_2$, $NiO_3$, $Ni_nO_m$, $Fe_nOm$, $Ni_n(OH)_m$ and $Fe_n(OH)_m$,
   wherein n and m are an integer of more than or equal to 1, respectively.

8. The metal plate (100) of claim 5, wherein the surface layer (110, 120) includes a content (at%) of oxygen greater than a content (at%) of iron.

9. The metal plate (100) of claim 5, wherein the surface layer (110, 120) includes a content of oxygen of more than or equal to 30 at%.

10. The metal plate (100) of claim 1, wherein a thickness of the metal plate (100) is 10 to 30 $\mu$m.

11. The metal plate (100) of claim 1, comprising,
    a rolled invar.

12. The metal plate (100) of claim 1, comprising,
    a grain boundary having an average size of less than or equal to 30 $\mu$m.

13. The metal plate (100) of claim 1, wherein the metal plate (100) has a first surface (101) and a second surface (102) opposite to the first surface (101) and includes a first outer layer (100b) defined by a thickness range of less than or equal to 1 $\mu$m and higher to 0 $\mu$m from the first surface (101) and a second outer layer (100c) defined by a thickness range of less than or equal to 1 $\mu$m and higher to 0 $\mu$m from the second surface (102),
the first surface (101) includes a first surface hole (V1) and the second surface (102) includes a second surface hole (V2), and
a through-hole is formed by communicating the first surface hole (V1) with the second surface hole (V2).

14. The metal plate (100) of claim 1, wherein the metal plate (100) includes a plurality of through-holes,
wherein a diameter Cx in a horizontal direction and a diameter Cy in a vertical direction of a reference hole, which is any one of the through-holes, have a deviation of 2% to 10% from a diameter Cx in the horizontal direction and a diameter Cy in the vertical direction, in each of holes adjacent to the reference hole.

15. The metal plate (100) of claim 14, wherein a size deviation between the reference hole and adjacent holes is within $\pm 3$ $\mu$m.

16. The metal plate (100) of claim 14, wherein the through-holes is disposed in a row in a vertical axis and in a row in a horizontal axis.

17. The metal plate (100) of claim 13, wherein a width of the through-hole is 20 to 40 $\mu$m.

18. The metal plate (100) of claim 13, wherein a height (H1) of the first surface hole (V1) has a ratio of 1:3 to 30 to a thickness of the metal plate (100).


**Patentansprüche**

1. Metallplatte (100), die zur Herstellung einer Maske zur Abscheidung verwendet wird, wobei die Metallplatte (100) umfasst:

   eine Außenschicht (100b, 100c), die durch einen Dickenbereich von kleiner oder gleich 1 $\mu$m und und größer als 0 $\mu$m von einer Oberfläche der Metallplatte (100) definiert ist; und
   eine Innenschicht (100a), anders als die Außenschicht (100b, 100c),
   wobei die Außenschicht (100b, 100c) und die Innenschicht (100a) Invar beinhalten,
   wobei die Metallplatte (100) zwei oder mehr Kristallebenen umfasst, die unterschiedliche Ausrichtungen zueinander aufweisen,
   wobei ein Anteil einer {220}-Kristallebene der Außenschicht (100b, 100c) größer als jenes einer {220}-Kristallebene der Innenschicht (100a) ist.

2. Metallplatte (100) nach Anspruch 1, wobei die Außenschicht (100b, 100c) eine {220}-Kristallebene, eine {200}-Kristallebene und eine {111}-Kristallebene beinhaltet,
   wobei ein Anteil der {220}-Kristallebene der Außenschicht (100b, 100c) 50 % bis 70 % beträgt.

3. Metallplatte (100) nach Anspruch 1, wobei eine Beugungsintensität von Röntgenstrahlen einer {200}-Kristallebene der Außenschicht (100b, 100c) größer als jene einer {200}-Kristallebene der Innenschicht (100a) ist, die innerhalb von 10 $\mu$m von der Oberfläche der Metallplatte (100) gemessen wird.

4. Metallplatte (100) nach Anspruch 1, wobei der Anteil der {220}-Kristallebene der Innenschicht (100a), die innerhalb von 10 $\mu$m von der Oberfläche der Metallplatte (100) gemessen wird, größer als jener einer {111}-Kristallebene der Innenschicht (100a) ist, die innerhalb von 10 $\mu$m von der Oberfläche der Metallplatte (100) gemessen wird.

5. Metallplatte (100) nach Anspruch 1, wobei die Außenschicht (100b, 100c) eine Oberflächenschicht (110, 120) beinhaltet, die eine Dicke von 10 bis 30 nm von der Oberfläche der Metallplatte (100) aufweist,
   wobei die Oberflächenschicht (110, 120) mindestens eines von einem Metalloxid und einem Metallhydroxid beinhaltet.

6. Metallplatte (100) nach Anspruch 5, wobei die Oberflächenschicht (110, 120) Sauerstoff von mehr als oder gleich 0,1 Gew.-% beinhaltet.

7. Metallplatte (100) nach Anspruch 5, wobei die Oberflächenschicht (110, 120) mindestens eines von FeO, NiO, FeOH, NiOH, $Fe(OH)_2$, $Fe(OH)_3$, $NiO_2$, $NiO_3$, $Ni_nO_m$, $Fe_nO_m$, $Ni_n(OH)_m$ und $Fe_n(OH)_m$ beinhaltet,

wobei n und m jeweils eine ganze Zahl größer als oder gleich 1 sind.

8.  Metallplatte (100) nach Anspruch 5, wobei die Oberflächenschicht (110, 120) einen Gehalt (At.-%) an Sauerstoff größer als einen Gehalt (At.-%) an Eisen beinhaltet.

9.  Metallplatte (100) nach Anspruch 5, wobei die Oberflächenschicht (110, 120) einen Gehalt an Sauerstoff von größer als oder gleich 30 At.-% beinhaltet.

10. Metallplatte (100) nach Anspruch 1, wobei eine Dicke der Metallplatte (100) 10 bis 30 μm beträgt.

11. Metallplatte (100) nach Anspruch 1, umfassend zusammengerolltes Invar.

12. Metallplatte (100) nach Anspruch 1, umfassend
    eine Korngrenze, die eine Durchschnittsgröße von kleiner als oder gleich 30 μm aufweist.

13. Metallplatte (100) nach Anspruch 1, wobei die Metallplatte (100) eine erste Oberfläche (101) und eine zweite Oberfläche (102) entgegengesetzt zur ersten Oberfläche (101) aufweist, und eine erste Außenschicht (100b), die durch einen Dickenbereich von kleiner als oder gleich 1 μm und und größer als 0 μm von der ersten Oberfläche (101) definiert ist, und eine zweite Außenschicht (100c), die durch einen Dickenbereich von kleiner als oder gleich 1 μm und und größer als 0 μm von der zweiten Oberfläche (102) definiert ist, beinhaltet, wobei die erste Oberfläche (101) ein erstes Oberflächenloch (V1) beinhaltet, und die zweite Oberfläche (102) ein zweites Oberflächenloch (V2) beinhaltet, und ein Durchgangsloch durch Verbinden des ersten Oberflächenloches (V1) mit dem zweiten Oberflächenloch (V2) gebildet wird.

14. Metallplatte (100) nach Anspruch 1, wobei die Metallplatte (100) eine Vielzahl von Durchgangslöchern beinhaltet, wobei ein Durchmesser Cx in einer horizontalen Richtung, und ein Durchmesser Cy in einer vertikalen Richtung eines Referenzloches, welches irgendeines der Durchgangslöcher ist, eine Abweichung von 2 % bis 10 % von einem Durchmesser Cx in der horizontalen Richtung und einem Durchmesser Cy in der vertikalen Richtung in jedem der Löcher angrenzend an das Referenzloch aufweisen.

15. Metallplatte (100) nach Anspruch 14, wobei eine Größenabweichung zwischen dem Referenzloch und angrenzenden Löchern innerhalb von ±3 μm liegt.

16. Metallplatte (100) nach Anspruch 14, wobei die Durchgangslöcher in einer Reihe in einer vertikalen Achse und in einer Reihe in einer horizontalen Achse angeordnet sind.

17. Metallplatte (100) nach Anspruch 13, wobei eine Breite des Durchgangsloches 20 bis 40 μm beträgt.

18. Metallplatte (100) nach Anspruch 13, wobei eine Höhe (H1) des ersten Oberflächenloches (V1) ein Verhältnis von 1:3 bis 30 zu einer Dicke der Metallplatte (100) aufweist.


**Revendications**

1.  Plaque métallique (100) utilisée pour la fabrication d'un masque pour un dépôt, la plaque métallique (100) comprenant :

    une couche externe (100b, 100c) définie par une plage d'épaisseur inférieure ou égale à 1 μm et supérieure à 0 μm à partir d'une surface de la plaque métallique (100) ; et
    une couche interne (100a) autre que la couche externe (100b, 100c),
    la couche externe (100b, 100c) et la couche interne (100a) comportant de l'invar,
    la plaque métallique (100) comprenant deux plans cristallins ou plus ayant des orientations différentes les uns des autres,
    dans laquelle une proportion d'un plan cristallin {220} de la couche externe (100b, 100c) est supérieure à celle d'un plan cristallin {220} de la couche interne (100a) .

2.  Plaque métallique (100) selon la revendication 1, dans laquelle la couche externe (100b, 100c) comporte un plan cristallin {220}, un plan cristallin {200} et un plan cristallin {111},
dans laquelle une proportion du plan cristallin {220} de la couche externe (100b, 100c) est de 50 % à 70 %

3. Plaque métallique (100) selon la revendication 1, dans laquelle une intensité de diffraction des rayons X d'un plan cristallin {200} de la couche externe (100b, 100c) est supérieure à celle d'un plan cristallin {200} de la couche interne (100a) mesurée à un intérieur de 10 $\mu$m par rapport à la surface de la plaque métallique (100) .

4. Plaque métallique (100) selon la revendication 1, dans laquelle la proportion du plan cristallin {220} de la couche interne (100a) mesurée à un intérieur de 10 $\mu$m par rapport à la surface de la plaque métallique (100) est supérieure à celle d'un plan cristallin {111} de la couche interne (100a) mesurée à un intérieur de 10 $\mu$m par rapport à la surface de la plaque métallique (100) .

5. Plaque métallique (100) selon la revendication 1, dans laquelle la couche externe (100b, 100c) comporte une couche de surface (110, 120) ayant une épaisseur de 10 à 30 nm par rapport à la surface de la plaque métallique (100), dans laquelle la couche de surface (110, 120) comporte au moins l'un parmi un oxyde de métal et un hydroxyde de métal.

6. Plaque métallique (100) selon la revendication 5, dans laquelle la couche de surface (110, 120) comporte de l'oxygène à plus de, ou égal à, 0,1 % en poids.

7. Plaque métallique (100) selon la revendication 5, dans laquelle la couche de surface (110, 120) comporte au moins l'un parmi FeO, NiO, FeOH, NiOH, $Fe(OH)_2$, $Fe(OH)_3$, $NiO_2$, $NiO_3$, $Ni_nO_m$, $Fe_nO_m$, $Ni_n(OH)_m$ et $Fe_n(OH)_m$, dans laquelle n et m sont un nombre entier supérieur ou égal à 1, respectivement.

8. Plaque métallique (100) selon la revendication 5, dans laquelle la couche de surface (110, 120) comporte une teneur (en % atomique) en oxygène supérieure à une teneur (en % atomique) en fer.

9. Plaque métallique (100) selon la revendication 5, dans laquelle la couche de surface (110, 120) comporte une teneur en oxygène supérieure ou égale à 30 % atomique.

10. Plaque métallique (100) selon la revendication 1, dans laquelle une épaisseur de la plaque métallique (100) est de 10 à 30 $\mu$m.

11. Plaque métallique (100) selon la revendication 1, comprenant,
un invar laminé.

12. Plaque métallique (100) selon la revendication 1, comprenant,
un joint de grain ayant une taille moyenne inférieure ou égale à 30 $\mu$m.

13. Plaque métallique (100) selon la revendication 1, dans laquelle la plaque métallique (100) possède une première surface (101) et une seconde surface (102) opposée à la première surface (101) et comporte une première couche externe (100b) définie par une plage d'épaisseur inférieure ou égale à 1 $\mu$m et supérieure à 0 $\mu$m à partir de la première surface (101) et une seconde couche externe (100c) définie par une plage d'épaisseur inférieure ou égale à 1 $\mu$m et supérieure à 0 $\mu$m à partir de la seconde surface (102),
la première surface (101) comporte un premier trou de surface (V1) et la seconde surface (102) comporte un second trou de surface (V2) et
un trou traversant est formé par la communication du premier trou de surface (V1) avec le second trou de surface (V2).

14. Plaque métallique (100) selon la revendication 1, dans laquelle la plaque métallique (100) comporte une pluralité de trous traversants,
dans laquelle un diamètre Cx dans une direction horizontale et un diamètre Cy dans une direction verticale d'un trou de référence, qui est l'un quelconque des trous traversants, ont un écart de 2 % à 10 % par rapport à un diamètre Cx dans la direction horizontale et un diamètre Cy dans la direction verticale, dans chacun parmi des trous adjacents au trou de référence.

15. Plaque métallique (100) selon la revendication 14, dans laquelle un écart de taille entre le trou de référence et les trous adjacents est dans les limites de $\pm$ 3 $\mu$m.

**16.** Plaque métallique (100) selon la revendication 14, dans laquelle les trous traversants sont disposés en une rangée selon un axe vertical et en une rangée selon un axe horizontal.

**17.** Plaque métallique (100) selon la revendication 13, dans laquelle une largeur du trou traversant est de 20 à 40 $\mu$m.

**18.** Plaque métallique (100) selon la revendication 13, dans laquelle une hauteur (H1) du premier trou de surface (V1) possède une proportion de 1:3 à 30 par rapport à une épaisseur de la plaque métallique (100).

Fig. 1

Fig. 2

Fig. 3

Fig. 4

Fig. 5

Fig. 6

Fig. 7

T1

100

Fig. 8

101        P1

100

102

P2

Fig. 9

V1    101    P1

CA

100

V2

102    P2

Fig. 10

Fig. 11

EXEMPLARY EMBODIMENT 1

COMPARATIVE EXAMPLE 1

Fig. 12

Fig. 13

Fig. 14

T1

100d

Fig. 15

110    101d

T2

T1

100d

T3

120    102d

Fig. 16

P1    110    101d    101

T2

T1

100d

T3

P2    120    102d    102

Fig. 17

Fig. 18

Fig. 19

90.30μm

50.10μm

Fig. 20

99.15μm

97.64μm

Fig. 21

Fig. 22

Fig. 23

Fig. 24

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0158178 A1

- US 4755257 A